# EUROPEAN PATENT APPLICATION

(11) **EP 4 203 412 A1**
(43) Date of publication of application: **28.06.2023**
(21) Application number: 22206653.2
(22) Date of filing: 10.11.2022
(51) Int. Cl.: H04L 41/0833, H04L 41/16, H04L 41/0823, H03K 19/17784, H04W 24/02, H04W 52/02

(54) **SYSTEM ENERGY EFFICIENCY IN A WIRELESS NETWORK**

(30) Priority: 22.12.2021 US 202117559287
(71) Applicant: INTEL Corporation, Santa Clara, CA 95054 (US)
(72) Inventor: KUMASHIKAR, Mahesh, 560066 Bangalore KA (IN); NALAMALPU, Ankireddy, Portland OR, 97229 (US); HOSSAIN, MD, Portland OR, 97229 (US); SUBBAREDDY, Dheeraj, Portland OR, 97229 (US); MAHESHWARI, Atul, Portland OR, 97229 (US); LI, Yuet, Fremont, CA, 94539 (US); IYER, Mahesh, Fremont, CA, 94539 (US)
(74) Representative: Viering, Jentschura & Partner mbB Patent- und Rechtsanwälte

(57) **Abstract**

The present disclosure relates to a device for use in a wireless network, the device including: a processor configured to: provide input data to a trained machine learning model, the input data representative of a network environment of the wireless network, wherein the trained machine learning model is configured to provide, based on the input data, output data representative of an expected performance of a plurality of configurations of network components with respect to power consumption and performance of the wireless network; select a configuration of a network component from the plurality of configurations based on the output data of the trained machine learning model; and instruct an operation of the network component according to the selected configuration; and a memory coupled with the processor, the memory storing the input data provided to the trained machine learning model and/or the output data from the trained machine learning model.

## Description

### Technical Field

The present disclosure relates to a device for use in a wireless network and methods thereof (e.g., a method of operating a wireless network, e.g. a method of selecting a configuration of one or more network components of the wireless network).

### Background

In general, various technologies and standards have been developed for wireless communication, which is at the basis of a variety of services and applications in everyday life, such as the consumption of entertainment content via streaming services, the implementation of automated driving functionalities via exchange of information with a road infrastructure, or the design of Internet of Things environments in an industrial or in a home setting, as examples. Software and hardware components of wireless networks are continuously evolving to satisfy the ever increasing number of connected users, and to ensure a fast and efficient transfer of information to and from the users. An important aspect of the operation of a wireless network is the optimization of power consumption for operating the network, and various strategies have been proposed to implement power savings, for example at a base station in a 5G network. The development of advanced strategies for power management and power savings in a wireless network is thus of fundamental importance for the development of wireless communications.

### Brief Description of the Drawings

In the drawings, like reference characters generally refer to the same parts throughout the different views. The drawings are not necessarily to scale, emphasis instead generally being placed upon illustrating the principles of the invention. In the following description, various aspects of the invention are described with reference to the following drawings, in which:
FIG.1A shows a wireless network in a schematic representation according to the present disclosure;
FIG.1B shows a wireless communication device in a schematic representation according to the present disclosure;
FIG.1C shows a network access node in a schematic representation according to the present disclosure;
FIG. ID shows a radio access network configured according to the ORAN concept in a schematic representation according to the present disclosure;
FIG.2A shows a device configured for dynamic power savings for use in a wireless network in a schematic representation according to the present disclosure;
FIG.2B shows a mapping of a configuration for providing a reduction in power consumption to the hardware components of a network access node in a schematic representation according to the present disclosure;
FIG.2C shows an exemplary application scenario for dynamic power savings in a schematic representation according to the present disclosure;
FIG.3A shows a machine learning model in a schematic representation according to the present disclosure;
FIG.3B shows a schematic flow diagram of a method of training a machine learning model according to the present disclosure;
FIG.4A shows a centralized learning environment in a schematic representation according to the present disclosure;
FIG.4B shows a distributed learning environment in a schematic representation according to the present disclosure; and
FIG.5 shows a schematic flow diagram of a method of operating a wireless network according to the present disclosure.

### Description

The following detailed description refers to the accompanying drawings that show, by way of illustration, specific details and aspects in which the invention may be practiced. These aspects are described in sufficient detail to enable those skilled in the art to practice the invention. Other aspects may be utilized and structural, logical, and electrical changes may be made without departing from the scope of the invention. The various aspects are not necessarily mutually exclusive, as some aspects may be combined with one or more other aspects to form new aspects. Various aspects are described in connection with methods and various aspects are described in connection with devices (e.g., a device for use in a wireless network, a network access node, etc.). However, it may be understood that aspects described in connection with methods may similarly apply to the devices, and vice versa.

With the advancements of new generations of wireless networks (e.g., 5G and beyond), there is a constant demand for improvements in the operation of the network, both for the network-side as well as for the user-side. For example, the vision behind the 5th Generation of wireless networks aims at providing seamless wide-area coverage and high-capacity hot spots, while ensuring low latency and high reliability, and with low power consumption. However, providing services to the ever increasing number of users is a non-trivial task in view of the limitations associated with power transmission (e.g., interference constraints, health considerations, cost, hardware limitations, etc.), and in view of the challenges posed by the use of the available radio spectrum, which is an intrinsically scarce resource.

In this context, strategies for saving power play an important role for the operation of a wireless network, to ensure a sustainable deployment of existing and future communication technologies. Serving an increasing number of connected user leads to the installation and use of an increasing number of hardware and software components to implement communication functionalities, so that a smart management of the network components to reduce the power consumption is of uttermost importance to provide a durable and environment-friendly operation of the network. For example, the 5G NR (5G New Radio) standards include several ways to implement power savings at a 5G base station, e.g. using configuration changes depending on user behavior, number of cells used in the system, overlapping cell coverage, capabilities of the base station (BS) hardware itself, and the like.

However, in a conventional approach, it is not clear which power savings strategy should be applied under what conditions. The decision of which power saving strategy to use is fairly static, and taken by network operators based on various heuristics taking into account some level of historical data. Current approaches do not adapt dynamically to the environment and are extremely crude. As an example, the operators may deactivate some cells entirely during the night, e.g. to reduce energy consumption based on historic data that shows very low or no traffic.

The present disclosure is related to a dynamic approach for implementing power savings in a wireless network (e.g., for 5G and beyond). The present disclosure is related to an approach based on selecting a configuration for the operation of network components that may provide a reduced power consumption, and based on selecting the configuration taking into account an actual network scenario, rather than based on static and predefined assumptions. Conventional approaches, e.g. based on power models introduced during the 4G era, may be based on maximizing the dual objective of cell capacity and power saving. The present disclosure may be based on the realization that, however, limiting power saving considerations to these two aspects is not sufficient to ensure a reliable system performance. For example, with 5G and beyond, other performance metrics such as throughput, latency, reliability, etc., should be considered along with power saving. Maximizing capacity and energy saving while overlooking other performance metrics may lead to suboptimal system performance.

The present disclosure is related to using machine learning techniques for selecting a configuration of one or more network components (illustratively, a configuration of the operation of the network components that may provide power savings) in a dynamic manner, e.g. adapting the selection to the network environment. The approach described herein may leverage input data, such as the load information, cell average capacity, throughput, time of day, network planning and deployment strategies, and the like, coupled with the information from possible power savings gain from different techniques to then pick the right technique under different load and traffic type combinations. In an exemplary configuration, the machine learning techniques described herein may provide system-level base station energy efficiency by formulating a multi-objective problem.

The strategy described herein may thus provide a dynamic approach to power savings in a wireless network, which may provide balancing among a plurality of performance metrics to select a configuration for the operation of network components that takes into consideration power savings as well as other aspects of the network performance.

The present disclosure relates to a device configured to dynamically select a configuration for the operation of network components to provide power savings in a given network scenario. Further, the present disclosure relates to a (computer-implemented) method of dynamically selecting a configuration for the operation of network components to provide power savings in a given network scenario.

The present disclosure relates to a device for use in a wireless network, the device including: a processor configured to: provide input data to a trained machine learning model, the input data describing a network environment of the wireless network, wherein the trained machine learning model is configured to provide, based on the input data, output data including a plurality of scores, each score of the plurality of scores being representative of an expected performance of a (respective) configuration of a plurality of configurations of one or more network components with respect to power consumption and performance of the wireless network; and instruct a configuration (e.g., instruct an operation) of the one or more network components based on the output data of the trained machine learning model.

The present disclosure further relates to a device for use in a wireless network, the device including: a processor configured to: provide input data to a trained machine learning model, the input data describing a network environment of the wireless network, wherein the trained machine learning model is configured to provide, based on the input data, output data representative of an expected performance of a plurality of configurations of one or more network components with respect to power consumption and performance of the wireless network; select a configuration of the plurality of configurations based on the output data of the trained machine learning model; and instruct an operation of the one or more network components according to the selected configuration. As an exemplary configuration the device may further include a memory coupled to the processor, e.g. a memory storing the input data and/or storing the output data.

The present disclosure further relates to a method of operating a wireless network, the method including: providing input data to a trained machine learning model, the input data describing a network environment of the wireless network, wherein the trained machine learning model is configured to provide, based on the input data, output data including a plurality of scores, each score of the plurality of scores being representative of an expected performance of a respective configuration of a plurality of configurations of one or more network components with respect to power consumption and performance of the wireless network; and instructing a configuration of the one or more network components based on the output data of the trained machine learning model.

The present disclosure further relates to a method of operating a wireless network, the method including: providing input data to a trained machine learning model, the input data describing a network environment of the wireless network, wherein the trained machine learning model is configured to provide, based on the input data, output data representative of an expected performance of a plurality of configurations of one or more network components with respect to power consumption and performance of the wireless network; selecting a configuration of the plurality of configurations based on the output data of the trained machine learning model; and instructing an operation of the one or more network components according to the selected configuration.

The present disclosure further relates to a method of operating a wireless network, the method including: determining, using a trained machine learning model, a configuration of one or more network components based on an expected performance of the configuration with respect to power consumption and performance of the wireless network in a network environment; and instructing an operation of the one or more network components based on the determined configuration.

The term "wireless network" as used herein, e.g. in reference to a communication network such as a mobile communication network, encompasses both an access section of a network (e.g., a radio access network (RAN) section) and a core section of a network (e.g., a core network section). A wireless network may provide communication and other types of services to one or more wireless communication devices, e.g. through network access nodes. A wireless network may be or may include a communication network in which the final communication link (e.g., to a wireless communication device) is wireless, e.g. over an air interface. In a given location one or more wireless networks may be deployed, each supporting a radio access technology (RAT) and operating in a respective frequency range. A "wireless network" may also be referred to herein as "radio communication network" or "wireless system".

The term "network access node" as used herein refers to a network-side device that provides an access network (e.g., a radio access network). A "network access node" may allow wireless communication devices to connect and exchange information with a core network and/or external data networks through the network access node. A "network access node" may thus be or include any device that may be configured to allow a wireless communication device to access a wireless network. A "network access node" may provide coverage for a macro cell, a micro cell, a pico cell, a femto cell, and/or another type of cell of the wireless network. A "network access node" may include any type of base station or access point, including macro base stations, micro base stations, NodeBs, evolved NodeBs (eNBs), New Radio NodeBs (gNBs), Home base stations, Remote Radio Heads (RRHs), relay points, Wi-Fi/WLAN Access Points (APs), Bluetooth master devices, dedicated short-range communication roadside units (DSRC RSUs), wireless communication devices acting as network access nodes, multi-standard radio (MSR) equipment, and any other electronic device capable of network-side wireless communications, including both immobile and mobile devices (e.g., vehicular network access nodes, moving cells, and other movable network access nodes). A network access node may include any suitable combination of hardware and/or software to perform the tasks, features, functions and methods disclosed herein. A "network access node" may also be referred to herein as "RAN node", or simply as "network node".

The term "wireless communication device" as used herein refers to user-side devices (both portable and fixed) that may connect to a core network and/or external data networks via an access network, e.g. through a network access node. A "wireless communication device" may be configured to communicate wirelessly with other wireless communication devices and/or with a network access node of a wireless network. A wireless communication device may communicate with a network access node via downlink and uplink. "Downlink" may describe the communication link from the network access node to the wireless communication device, and "uplink" may describe the communication link from the wireless communication device to the network access node.

A "wireless communication device" may be or may include any mobile or immobile wireless communication device, including User Equipment (UEs), Mobile Stations (MSs), Stations (STAs), cellular phones, gaming consoles, tablets, laptops, personal computers, wearables, multimedia playback and other handheld or body-mounted electronic devices, consumer/home/office/commercial appliances (e.g., a smart television, a smart refrigerator, etc., in an Internet of Things implementation), vehicles (e.g., a car, or a drone), a robot, and any other electronic device capable of user-side wireless communications. Without loss of generality, in some cases wireless communication devices may also include application-layer components, such as application processors or other general processing components that are directed to functionality other than wireless communications. A wireless communication device may optionally support wired communications in addition to wireless communications. Furthermore, wireless communication devices may include vehicular communication devices that function as wireless communication devices. Certain communication devices may act both as wireless communication devices and network access nodes, such as a wireless communication device that provides network connectivity for other wireless communication devices. A "wireless communication device" may also be referred to herein as "terminal device" (to indicate that the wireless communication device represents the end terminal of a wireless connection), or simply as "wireless device".

The term "user" may be used herein in general to indicate a user of a wireless network, e.g. to indicate a "user of a wireless communication device" or to indicate a wireless communication device itself communicating or attempting to communicate with the wireless network. Illustratively, a "user" in the context of a wireless network may be understood as an entity that may access the wireless network and communicate via the wireless network. A "user" may be, for example, a person, e.g. the owner of a mobile phone, a smartphone, a tablet, etc. A user may however also be a technological entity, e.g. a wireless communication device itself, for example a robot, a smart sensor, a vehicle, etc. that may access the wireless network and communicate via the wireless network independently of the presence of a human operating or otherwise controlling the technological entity.

The term "network environment" as used herein may describe a state of a wireless network, e.g. at a given time point, for example in relation to communication occurring over the wireless network. A "network environment" as used herein may refer to one or more properties of an operating scenario of the wireless network, e.g. to a number of users, downlink/uplink requirements of the users, data rate, cell occupation, and the like. A "network environment" as used herein may refer to an operating scenario of a cell or a network access node of the wireless network, as examples. A "network environment" may also be referred to herein as "network scenario". For example, a "network environment" may be or include a "radio access network environment", e.g. the environment of the "access network" portion of a wireless network.

The term "network component" as used herein may describe any hardware and/or software entity for use in a wireless network. A "network component" as used herein may be or include a hardware-based component of a wireless network, such as a cell, a network access node (a base station), a server, transmission medium, an antenna, a transmitter, a receiver, a local oscillator, processing circuitry, a filter, and the like. A "network component" as used herein may be a software-based component of a wireless network, such as a protocol, a model, an operating system, a function (e.g., a user-plane function, an authentication function, a policy control function, etc.), and the like. A "network component" may be or include a combination of hardware-based component(s) and software-based component(s), e.g. software running on hardware, e.g. hardware controlled via software. Illustratively, a "network component" may be or may include any type of technological, physical and/or logical entity for use in a wireless network. A "network component" may be a node, or a module (e.g., a hardware module or software module) of a wireless network, as examples.

A "configuration of a network component" or a "configuration of one or more network components" as used herein may describe a configuration of the network component(s) for (or during) its/their operation. A "configuration of one or more network components" may refer to how the one or more network components operate or are instructed to operate, e.g. to implement one or more functionalities of a wireless network (such as, data transmission, data reception, authentication, handover, etc.). As illustrative examples, a "configuration of a network component" may include a power at which an antenna transmits a signal, a frequency at which an antenna transmits a signal, a direction at which a base station transmits a signal, a number of users that a base station serves simultaneously, a modulation that a controller imposes onto a signal, etc. A "configuration of a network component" may be understood as a "configuration for the operation of the network component", and a "configuration of one or more network components" may be understood as a "configuration for the operation of the one or more network components".

In the context of the present disclosure, the terms "energy", "power", "energy consumption", and "power consumption" may be used as known in the art, e.g. to describe the electrical energy transferred during operation of a wireless network (e.g., during communication) and the rate at which energy is transferred. In the context of communications in a wireless network, an energy consumption may be expressed in energy per unit of data (e.g., bits-per-Joule), and a power consumption may be expressed in power per unit of data (e.g., Watt/bit). In the context of the present disclosure a reduced (or increased) energy or energy consumption may correspond to a reduced (or increased) power or power consumption, and vice versa. In the context of the present disclosure a "power saving(s)" may be also understood as an "energy saving(s)", and vice versa, and a "power saving mechanism" may also be understood as an "energy saving mechanism", and vice versa. A power (or energy) saving mechanism may also be referred to herein as power saving technique, or power saving strategy.

The term "model" used herein may be understood as any kind of algorithm, which provides output data based on input data provided to the model (e.g., any kind of algorithm generating or calculating output data based on input data). A computing system may execute a model to progressively improve performance of a specific task. A "model" may be, for example, a "machine learning model". A machine leaning model may be a model trained to recognize patterns in data (illustratively, in observations). Parameters of a machine learning model may be adjusted during a training phase based on training data. A trained machine learning model may be used during an inference phase to make estimations or decisions based on input data. In some aspects, the trained machine learning model may be used to generate additional training data. An additional machine learning model may be adjusted during a second training phase based on the generated additional training data. A trained additional machine learning model may be used during an inference phase to make estimations or decisions based on input data. A "machine learning" model may provide an "artificial intelligence" for carrying out a task modelled using the machine learning model.

The machine learning models described herein may take any suitable form or utilize any suitable technique (e.g., for training purposes). For example, any of the machine learning models may utilize supervised learning, semi-supervised learning, unsupervised learning, or reinforcement learning techniques.

In supervised learning, the model may be built using a training set of data including both the inputs and the corresponding desired outputs (illustratively, each input may be associated with a desired or expected output for that input). Each training instance may include one or more inputs and a desired output. Training may include iterating through training instances and using an objective function to teach the model to estimate the output for new inputs (illustratively, for inputs not included in the training set). In semi-supervised learning, a portion of the inputs in the training set may be missing the respective desired outputs (e.g., one or more inputs may not be associated with any desired or expected output).

In unsupervised learning, the model may be built from a training set of data including only inputs and no desired outputs. The unsupervised model may be used to find structure in the data (e.g., grouping or clustering of data points), illustratively, by discovering patterns in the data. Techniques that may be implemented in an unsupervised learning model may include, e.g., self-organizing maps, nearest-neighbor mapping, k-means clustering, and singular value decomposition.

Reinforcement learning models may include positive feedback (also referred to as reward) or negative feedback to improve accuracy. A reinforcement learning model may attempt to maximize one or more objectives/rewards. Techniques that may be implemented in a reinforcement learning model may include, e.g., Q-learning, temporal difference (TD), and deep adversarial networks.

A machine learning model described herein may be or may include a neural network. The neural network may be any kind of neural network, such as a convolutional neural network, an auto-encoder network, a variational auto-encoder network, a sparse auto-encoder network, a recurrent neural network, a de-convolutional network, a generative adversarial network, a forward thinking neural network, a sum-product neural network, and the like. The neural network may include any number of layers. The training of the neural network (e.g., adapting the layers of the neural network) may use or may be based on any kind of training principle, such as backpropagation (e.g., using the backpropagation algorithm).

In the context of the present disclosure it is understood that references to a wireless network, to power savings in a wireless network, and to estimating or forecasting the performance of a configuration of one or more network components, etc. may refer to a real-world scenario, i.e. to a wireless network existing in the real-world (illustratively, in the physical world) and to a configuration of real-world network components. It is however understood that, in principle, the strategy described herein could also apply to a virtual-world wireless network, illustratively to select a configuration of virtual network components in a virtual environment. A virtual-world wireless network may for example be or include a computer-implemented simulation of a wireless network, in which the components and the interactions of the virtual wireless network are computer-simulated to represent the corresponding real-world components and interactions of a corresponding real-world wireless network. A virtual-world wireless network may be part of a video game, a simulation environment, or a virtual reality implementation, as examples.

In the present disclosure, various aspects are described with terminology that may pertain to particular radio communication technologies, e.g. with terminology that may pertain to the 5G context. It is however understood that the aspects described herein may correspondingly apply to other radio communication technologies, in which same (e.g., structurally same and/or functionally same) components, structures, operations, logic entities, etc. may be referred to with other terms pertaining to the other radio communication technologies.

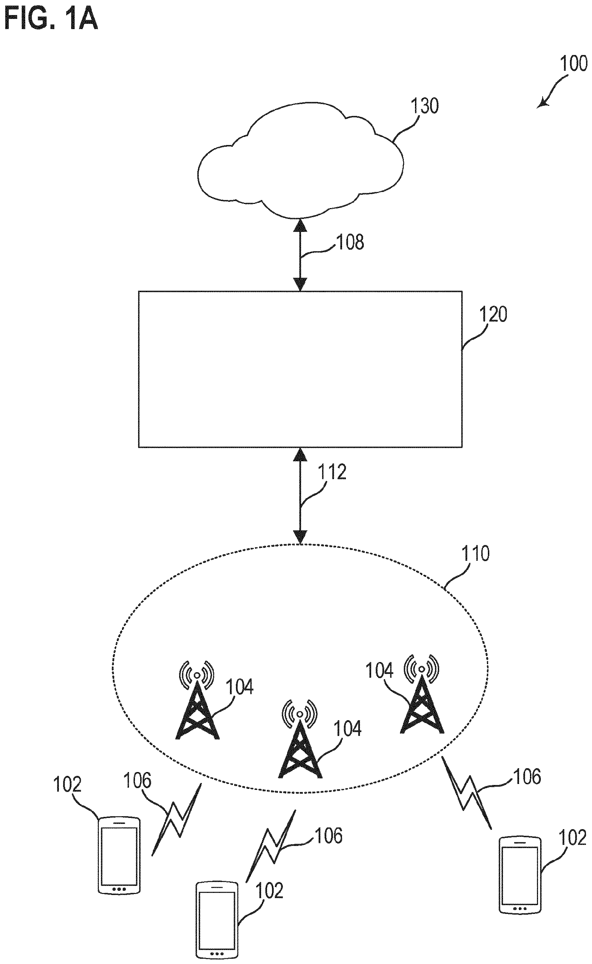

**FIG.1A** shows a wireless network 100 in a schematic representation according to the present disclosure. The wireless network 100 may communicate with one or more wireless communication devices 102 via one or more network access nodes 104, e.g. over a physical interface 106 (e.g., an air interface). It is understood that the number of network access nodes 104 and wireless communication devices 102 in wireless network 100 is exemplary and is scalable to any amount.

The wireless network 100 may communicate with the one or more wireless communication devices 102 via various mechanisms. In an exemplary configuration, the wireless network 100 may be an ad-hoc network, which may be self-organizing, i.e., the ad-hoc network may be composed of devices that are not pre-configured to have certain roles. Any device may independently become part of wireless network 100, such as via self-configuration and/or registration with other devices. The ad-hoc network may include heterogeneous devices or homogenous devices. Homogeneous devices may all have the same properties, such as computational power, communication rate, communication technologies, etc. Heterogeneous devices on the other hand, may have varying properties.

In the following, the wireless network 100 will be described with particular reference to the cellular context. It is however understood that the description of the wireless network 100 may correspondingly apply to other configurations of the wireless network, e.g. in the case that the wireless network 100 is or includes a sound wave access network (with communication based on sound waves), or an optical access network (with communication based on visible or non-visible light). Furthermore, in the following some configurations of the wireless network 100 may be described in relation to particular radio access network contexts (e.g., 5G, O-RAN, etc.); it is however understood that the description of the wireless network 100 may correspondingly apply to other contexts and other types or configurations of a (radio) access network.

Considering the cellular context, the one or more wireless communication devices 102 may be or may include cellular terminal devices (e.g., Mobile Stations (MSs), User Equipment (UEs), or any type of cellular terminal device). The one or more network access nodes 104 may be or may include base stations (e.g., eNodeBs, NodeBs, gNodeBs, Base Transceiver Stations (BTSs), or any other type of base station). The one or more network access nodes 104 may be part of an access network 110 (e.g., a radio access network) of the wireless network 100. The access network 110 may be, for example, an Evolved Universal Mobile Telecommunications System (UMTS) Terrestrial Radio Access Network (E-UTRAN), a NextGen RAN (NG RAN), an O-RAN, a virtual RAN (vRAN), or some other type of RAN. The wireless network 100 may be a heterogeneous network including network access nodes 104 of different types, such as macro base stations, micro base stations, pico base stations, femto bases stations, etc. Considering an exemplary short-range context, as an alternative, the one or more network access nodes 104 may be or may include access points (APs, e.g., WLAN or WiFi APs), while the one or more wireless communication devices 102 may be or may include short range terminal devices (e.g., stations, STAs). In the short-range context, the one or more network access nodes 104 may interface (e.g., via an internal or external router) with one or more external data networks.

In accordance with some radio communication network technologies, the one or more wireless communication devices 102 may execute mobility procedures to connect to, disconnect from, and switch between available network access nodes 104 of the access network 110. Wireless communication devices 102 may be configured to select and re-select between the available network access nodes 104 in order to maintain a strong radio access connection with the access network 110.

Considering the cellular context, the wireless network 100 may further include a core network 120, with which the one or more network access nodes 104 may interface, e.g. via backhaul interfaces. The core network 120 may be or may include an Evolved Packet Core (EPC, for LTE), Core Network (CN, for UMTS), 5G core network (5GC), as examples, or other cellular core networks. The core network 120 may interface with one or more external data networks 130, e.g. via a suitable interface 108 (e.g., a N6 interface). The core network 120 may provide switching, routing, and transmission, for traffic data related to wireless communication devices 102, and may further provide access to various internal data networks (e.g., control nodes, routing nodes that transfer information between other wireless communication devices on wireless network 100, etc.) and external data networks 130 (e.g., data networks providing voice, text, multimedia (audio, video, image), and other Internet and application data). As an example, the one or more external data networks 130 may include one or more packet data networks, PDNs. A wireless communication device 102 may thus establish a data connection with external data networks 130 via a network access node 104 and core network 120 for data transfer and routing.

The access network 110 and core network 120 of wireless network 100 may be governed by communication protocols that can vary depending on the specifics of wireless network 100. Such communication protocols may define the scheduling, formatting, and routing of both user and control data traffic through wireless network 100, which includes the transmission and reception of such data through both the radio access and core network domains of wireless network 100. Accordingly, wireless communication devices 102 and network access nodes 104 may follow the defined communication protocols to transmit and receive data over the radio access network domain of wireless network 100, while the core network 120 may follow the defined communication protocols to route data within and outside of the core network 120. Exemplary communication protocols include LTE, UMTS, GSM, WiMAX, Bluetooth, WiFi, mmWave, etc., any of which may be applicable to wireless network 100.

Illustratively, the one or more network access nodes 104 (and, optionally, other network access nodes of wireless network 100 not explicitly shown in FIG.1A) may accordingly provide a (radio) access network 110 to wireless communication devices 102 (and, optionally, other wireless communication devices of wireless network 100 not explicitly shown in FIG.1A). In an exemplary cellular context, the (radio) access network provided by the one or more network access nodes 104 may enable the one or more wireless communication devices 102 to wirelessly access the core network 120 via radio communications.

The core network 120 may include one or more core network nodes (not shown in FIG.1A) configured to implement various functionalities associated with the core network 120, depending on the radio communication technology context. As examples, the core network 120 may include one or more of: a network interface, a broadcast multicast service center (BM-SC), a mobility management entity (MME), a packet data network (PDN) gateway, a visitor location register (VLR), a multimedia broadcast multicast service (MBMS) gateway, a gateway mobile switching center (GMSC), an access and mobility management function (AMF), a session management function (SMF), a user plane function (UPF), a policy control function (PCF), a signaling gateway (SGW), a unified data management (UDM), a network slice selection function (NSSF), an authentication server function (AUSF), an application function, and/or the like.

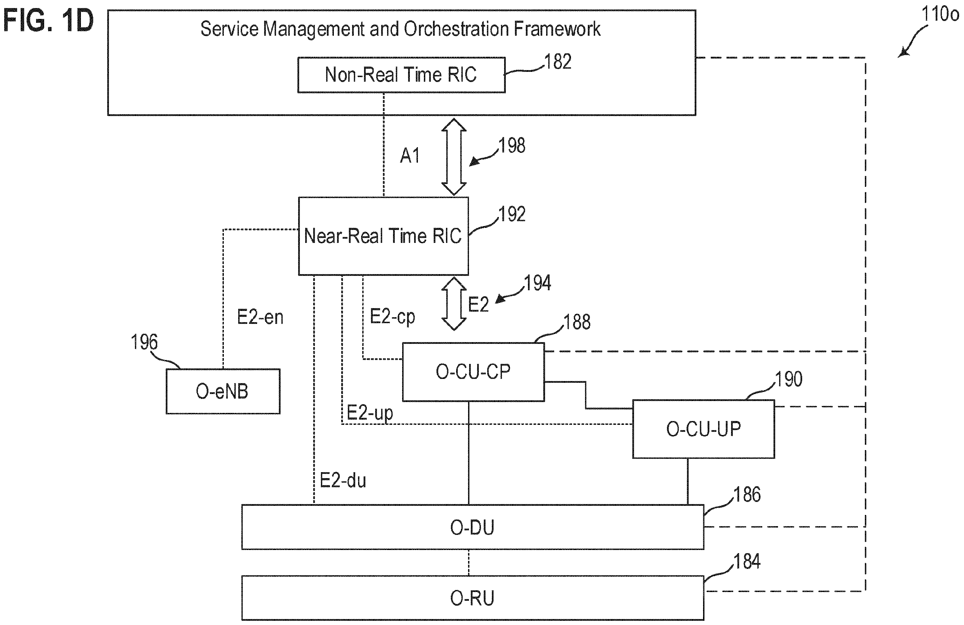

The one or more network access nodes 104 may be configured to perform various functions of the access network 110, such as uplink and downlink management, data packet scheduling, radio network controller, ciphering and deciphering, handover, synchronization, and/or the like. The one or more network access nodes 104 may be communicatively coupled to the core network 120 via a suitable interface 112, e.g. a S1 interface (for example including a S1-U interface and a serving gateway, S-GW). The one or more network access nodes 104 may communicate with each other, e.g. directly or indirectly, via wired or wireless communication links. In an exemplary configuration, the access network 110 may be configured according to the Open Radio Access Network or Open RAN concept, as described in further detail in FIG.1D.

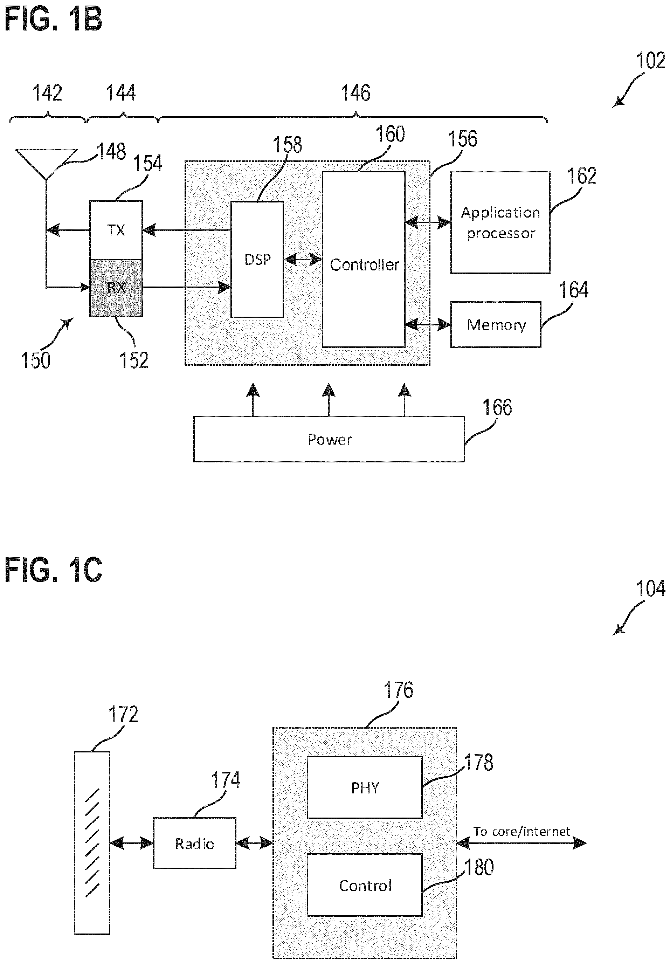

In the following, in relation to FIG.1B and FIG.1C, exemplary configurations of a wireless communication device and a network access node will be described. In general, the configuration of a wireless communication device and/or a network access node for wireless communications may be known in the art. A brief description is provided herein to introduce a context for the present disclosure.

**FIG.1B** shows a wireless communication device 102 in a schematic representation according to the present disclosure. In general, a wireless communication device 102 may include an antenna system 142 (also referred to herein as antenna circuitry), transceiver system 144 (also referred to herein as transceiver circuitry), and a processing system 146 (also referred to herein as signal processing circuitry). In the following a description of exemplary components for the various sections 142, 144, 146 of the wireless communication device 102 will be provided.

It is understood that the configuration illustrated in FIG.1B is exemplary, and a wireless communication device 102 may include additional, less, or alternative components with respect to those shown. As examples, the wireless communication device 102 may include one or more additional hardware and/or software components depending on its configuration and its intended use, such as processors/microprocessors, controllers/microcontrollers, other specialty or generic hardware/processors/circuits, peripheral device(s), power supply, external device interface(s), subscriber identity module(s) (SIMs), user input/output devices (display(s), keypad(s), touchscreen(s), speaker(s), external button(s), camera(s), microphone(s), etc.), or other related components.

Wireless communication device 102 may be configured to transmit and receive radio frequency signals via the antenna system 142, which may include one or more directional or omnidirectional antennas 148, e.g. a single antenna 148 or an antenna array that includes multiple antennas 148. The one or more antennas 148 may include, for example, dipole antennas, monopole antennas, patch antennas, loop antennas, microstrip antennas, or other types of antennas suitable for transmission of radio frequency signals. As an exemplary configuration, an antenna 148 may have multiple apertures, each of which may be considered as an antenna. In an exemplary configuration, the antenna system 142 may additionally include analog antenna combination and/or beamforming circuitry.

Transceiver system 144 may include a radio frequency (RF) transceiver 150, having a receive (RX) path 152 and a transmit (TX) path 154. The RF transceiver 150 may include analog and digital reception components including amplifiers (e.g., Low Noise Amplifiers (LNAs)), Power Amplifiers (PAs), filters, RF demodulators (e.g., RF IQ demodulators)), and analog-to-digital converters (ADCs), which RF transceiver 150 may utilize to convert radio frequency signals to digital baseband samples. In the receive (RX) path 152, the RF transceiver 150 may be configured to receive analog radio frequency signals from the antenna system 142 and perform analog and digital RF front-end processing on the analog radio frequency signals to produce digital baseband samples (e.g., In-Phase/Quadrature (IQ) samples). In the transmit (TX) path 154, the RF transceiver 150 may be configured to receive digital baseband samples from the processing system 146 (e.g., from a baseband modem 156 of the processing system 146) and perform analog and digital RF front-end processing on the digital baseband samples to produce analog radio frequency signals to provide to the antenna system 142 for wireless transmission. The RF transceiver 150 may thus also include analog and digital transmission components, which RF transceiver 150 may utilize to mix the digital baseband samples received from the processing system 146 and produce the analog radio frequency signals for wireless transmission by the antenna system 142.

The processing system 146 may be configured for transmission and reception processing. The processing system 146 may include, for example, a baseband modem 156 (e.g., including a digital signal processor 158 and a protocol controller 160), an application processor 162, a memory 164, and a power supply 166. The baseband modem 156 may be configured to direct the communication functionality of wireless communication device 102 according to the communication protocols associated with each (radio) access network, and may be configured to execute control over antenna system 142 and RF transceiver 154 to transmit and receive radio signals according to the formatting and scheduling parameters defined by each communication protocol.

The baseband modem 156 may include a digital signal processor 158, which may be configured to perform physical layer (PHY, Layer 1) transmission and reception processing to, in the transmit path 154, prepare outgoing transmit data that the protocol controller 160 provides for transmission via RF transceiver 150, and, in the receive path 152, prepare incoming received data that the RF transceiver 150 provides for processing by the protocol controller 160. Digital signal processor 158 may be configured to perform one or more of error detection, forward error correction encoding/decoding, channel coding and interleaving, channel modulation/demodulation, physical channel mapping, radio measurement and search, frequency and time synchronization, antenna diversity processing, power control and weighting, rate matching/de-matching, retransmission processing, interference cancellation, and any other physical layer processing functions.

The wireless communication device 102 may be configured to operate according to one or more radio communication technologies, and the digital signal processor 158 may be responsible for lower-layer processing functions (e.g., PHY, Layer 1) of the radio communication technologies, while the protocol controller 160 may be responsible for upper-layer protocol stack functions (e.g., Data Link Layer/Layer 2 and/or Network Layer/Layer 3). Protocol controller 160 may thus be responsible for controlling the radio communication components of wireless communication device 102 (antenna system 142, RF transceiver 150, and digital signal processor 158) in accordance with the communication protocols of each supported radio communication technology, and accordingly may represent the Access Stratum and Non-Access Stratum (NAS) (also encompassing Layer 2 and Layer 3) of each supported radio communication technology. Protocol controller 160 may be configured to perform both user-plane and control-plane functions to facilitate the transfer of application layer data to and from radio wireless communication device 102 according to the specific protocols of the supported radio communication technology. User-plane functions may include header compression and encapsulation, security, error checking and correction, channel multiplexing, scheduling and priority, while control-plane functions may include setup and maintenance of radio bearers.

In an exemplary configuration, wireless communication device 102 may be configured to transmit and receive data according to multiple radio communication technologies. Accordingly, one or more of antenna system 142, RF transceiver 150, digital signal processor 158, and/or protocol controller 160 may include separate components or instances dedicated to different radio communication technologies and/or unified components that are shared between different radio communication technologies. Accordingly, while antenna system 142, RF transceiver 150, digital signal processor 158, and protocol controller 160 are shown as individual components in FIG.1B, it is understood that they may encompass separate components dedicated to different radio communication technologies.

The processing system 146 may further include an application processor 162 (e.g., a CPU) and a memory 164. Application processor 162 may be configured to handle the layers above the protocol stack, including the transport and application layers. Application processor 162 may be configured to execute various applications and/or programs of wireless communication device 102 at an application layer of wireless communication device 102, such as an operating system (OS), a user interface (UI) for supporting user interaction, and/or various user applications. The application processor 162 may interface with baseband modem 156 and act as a source (in the transmit path) and a sink (in the receive path) for user data, such as voice data, audio/video/image data, messaging data, application data, basic Internet/web access data, etc. Memory 164 may embody a memory component of wireless communication device 102, such as a hard drive or another such permanent memory device. Although not explicitly depicted in FIG1B, the various other components of wireless communication device 102 may additionally each include integrated permanent and/or non-permanent memory components, such as for storing software program code, buffering data, etc.

**FIG.1C** shows a network access node 104 in a schematic representation according to the present disclosure. As an exemplary application scenario, a network access node 104 may be configured to provide LTE and/or 5G radio services. In general, the network access node 104 may include an antenna system 172 (also referred to herein as antenna circuitry), transceiver system 174 (also referred to herein as transceiver circuitry), and a baseband system 176 (e.g., including a physical layer processor 178 and a protocol controller 180).

In an abridged overview of the operation of network access node 104, network access node 104 may be configured to transmit and receive radio frequency signals via antenna system 172, which may be an antenna array including multiple antennas. Radio transceiver 174 may be configured to perform transmit and receive RF processing to convert outgoing baseband samples from baseband subsystem 176 into analog radio signals to provide to antenna system 172 for radio transmission, and may be configured to convert incoming analog radio signals received from antenna system 172 into baseband samples to provide to baseband subsystem 176. Physical layer processor 178 may be configured to perform transmit and receive PHY processing on baseband samples received from radio transceiver 174 to provide to controller 180, and may be configured to perform transmit and receive PHY processing on baseband samples received from controller 180 to provide to radio transceiver 174. Controller 180 may be configured to control the communication functionality of network access node 104 according to the corresponding radio communication technology protocols, which may include exercising control over antenna system 172, radio transceiver 174, and physical layer processor 178.

In an exemplary configuration, the network access node 104 may be configured to serve one or more wireless communication devices using beamforming techniques and/or coordinated spatial techniques, e.g. may be configured to transmit a beamformed signal to a wireless communication device in one or more directions.

Network access node 104 may thus be configured to provide the functionality of network access nodes in wireless networks by providing an access network to enable served wireless communication devices to access communication data. For example, network access node 104 may also interface with a core network, one or more other network access nodes, or various other data networks and servers via a wired or wireless backhaul interface.

**FIG.1D** shows a radio access network 110o in a schematic representation according to the present disclosure. The radio access network 110o may be an exemplary configuration of the access network 110 of wireless network 100. The radio access network 110o may be a radio access network configured according to the ORAN concept (also referred to herein as Open RAN, or O-RAN), illustratively the radio access network 110o may have an ORAN architecture. It is understood that the representation in FIG.1D is exemplary, and an ORAN architecture 110o may include additional, less, or alternative components with respect to those shown. The radio access network 110o may include non-proprietary hardware and software components, based on open interfaces and standards. The configuration in FIG.1D may illustrate a radio access network 110o configured for 4G and 5G wireless communications, but it is understood that other configurations of the radio access network 110o may be provided, e.g. to serve only one of 4G or 5G, or to serve other types of wireless communications.

Considering the Open-RAN concept, the radio access network 110o may include a management-side and a radio-side. The management-side may be configured to implement management functions of the RAN. The management side (also referred to as service management and orchestration framework) may include a non-real time RAN intelligent controller 182 (non-real time RIC, non-RT RIC) configured to implement non-real time control of RAN components and resources. The non-real time RIC 182 may be configured to implement functionalities to support intelligent RAN optimization, such as service and policy management, configuration management, device management, fault management, performance management, and lifecycle management for the network elements. For example, the non-real time RIC 182 may use machine learning models to implement the various functionalities. The functionalities of the non-real time RIC 182 may have non-real time latency.

The radio-side of the radio access network 110o may be configured to implement functions on a shorter time scale with respect to the management-side, e.g. functionalities with near-real time or real-time latency. The radio-side of the radio access network 110o may include: a radio unit 184 (RU, or O-RU to describe the network function) configured to transmit, receive, amplify, and/or digitize radio frequency signals; and a baseband unit (BBU), which may include a distributed unit 186 (DU, or O-DU to describe the network function) configured to carry out baseband processing functions (e.g., in real time), and a centralized unit (CU, or O-CU to describe the network function) configured to carry out packet processing functions (e.g., on a longer time scale with respect to the distributed unit). The centralized unit may include a centralized unit for the control plane 188 (CU-CP, or O-CU-CP), and a centralized unit for the user plane 190 (CU-UP, or O-CU-UP). The distributed unit 186 may be configured to run the radio link control and medium access control (MAC) layers. The centralized unit may be configured to control the distributed unit, and to run radio resource control protocol. The interfaces between the various components (e.g., the RU, DU, CU) may be non-proprietary (illustratively, open), which may allow the DU and CU to be implemented as virtualized software functions, as an example. As an exemplary scenario, a distributed unit 186 may be implemented at a network access node 196 (or in general not at a core network location), whereas a centralized unit may be implemented at a network access node 196 or at a more central location in the network. A radio unit may be located near or integrated into an antenna of a network access node 196.

The distributed unit and the centralized unit may be logical nodes of the ORAN architecture, configured for the computations related to signal transmission and reception.

The radio-side may further include a near-real time RAN intelligent controller 192 (near-real time RIC, near-RT RIC) configured to carry out near-real time control of RAN components and resources. The near-real time RIC 192 may be configured to implement control of RAN components over a so-called E2 interface 194, e.g. providing an interface between the near-real time RIC 192 and the other components at the radio-side (e.g., there may be an E2 interface with the distributed unit 186, E2-du, and centralized unit 188, 190, E2-cp, E2-up). The near-real time RIC 192 may also be configured to receive data over the E2 interface 194, e.g. from a network access node 196 of the radio access network 110o. The E2 interface may provide a connection between near-real time RIC 192 and network access node 196, so that the near-real time RIC 192 may control one or more functions of the network access node 196. The network access node 196 may be an E2 node, also referred to as O-eNB (e.g., for the 4G context), or another type of network access node. The non-real time RIC 182 and the near-real time RIC 192 may be communicatively coupled with one another over an A1 interface 198. The A1 interface 198 may allow non-real time RIC 182 to provide information to near-real time RIC 192, such as model management information, enrichment information, and policy information.

The near-real time RIC 192 may provide a software environment for one or more software plug-ins, referred to as xAPP(s), which may be configured to instruct various functionalities of the near-real time RIC. A xAPP may be an application running in the near-real time RIC 192 for the management of resources and components of the radio access network 110o. Examples of xAPPs may include: connection management, mobility management, quality-of-service management, and/or interference management. A xAPP may receive near-real time information over the E2 interface 194. The near-real time RIC 192 may include or provide an interface for the xAPPs, e.g. an application programming interface (API), providing a path for exchange of information to and from the xAPPs.

The RAN intelligent controllers (e.g., the near-real time RIC 192 and non-real time RIC 182) may be functional components which may reside in various nodes and/or entities of a wireless network, for example on the host running the RAN software, in a networked device, or in the cloud assuming the respective latency can be met.

A further component of the ORAN architecture (not shown in FIG.1D) that the radio access network 110o may include is the so-called O-Cloud, which is a cloud computing platform for hosting and running various functionalities of the radio access network, such as functionalities of the RIC(s). The O-Cloud may include physical infrastructure nodes that may host O-RAN functions and software components for implementing the O-RAN functions, as known in the art.

Energy efficiency in a wireless network (e.g., in a 5G network) is an important aspect of the operation of the network to mitigate the high energy costs associated with the deployment of a wireless network (e.g., of a 5G network). However, current strategies aimed at operating a wireless network to reduce power consumption are implemented in a static manner, without taking into consideration the actual scenario, and thus the actual constraints, in which the wireless network is operating. As an example, a cellular network may be provisioned for peak load. However, the actual loads may vary significantly throughout the day and only very occasionally may reach peak loads. In this regard, a simple (static) strategy based on activating and deactivating a cell cannot take advantage of opportunities during the off-peak hours of the daytime when there is enough traffic to keep the cell active, but not running at peak capacity. For such times, other techniques may be preferable to reduce energy consumption, such as lowering the advertised bandwidth or using more macro vs. pico (or small) cells. Also, the current systems are not optimized for other key performance indicators (KPIs), such as latency, throughput, reliability etc.

The present disclosure is related to a dynamic approach of selecting a configuration for the operation of network components based on a (current) network environment. The approach described herein may rely on a trained machine learning model (e.g., a trained neural network) to select a configuration of the network components that provides power savings without deteriorating the performance of the wireless network. Illustratively, the approach described herein may be based on selecting a configuration of the network components that is known to provide power savings, and that is the most suitable (among possible configurations) in that particular network environment.

With respect to a conventional approach, the present disclosure relates to solving a multi-objective problem, taking into consideration not only the power-saving aspects of an operation of the network components, but also other performance-related parameters. A conventional approach, on the other hand, may address reducing energy consumption (e.g., of base stations) in a static manner, e.g. without using AI techniques for the different mechanisms and without applying it as a multi-objective problem. Furthermore, in 3GPP standards discussions on the use of AI models and techniques for network energy savings is limited to cell activation/deactivation alone, without taking into consideration other possible configurations of network components that may provide a reduced power consumption. For example, with the sub-millisecond processing and evolving architecture in 5G and beyond, it may be beneficial in terms of power savings to categorize the subcomponents of the RAN and determine respective sleep power, corresponding sleep times and exit latency from these sleep power level to meet transmission/reception requirements, rather than using a more crude approach.

The dynamic approach described herein may be particularly well suited for applications in an ORAN context, in view of the flexibility that the approach provides. Thus, in the following the terminology used to describe components, parameters, logic entities, etc. may pertain to the ORAN context. It is however understood that the dynamic approach described herein may apply also to other radio access network types or configurations, and that the operations and configurations described herein may apply in a corresponding manner to components, parameters, logic entities, etc. pertaining to other radio access network types or configurations.

Furthermore, the discussion in the following may relate in particular to an application of the dynamic approach described herein at a network access node (e.g., a base station, eNodeB, gNodeB, etc.) and/or at a cell of a wireless network. It is however understood that the approach may apply in a corresponding manner to dynamically select a power saving mechanism at other locations (other entities, other nodes, etc.) of a wireless network.

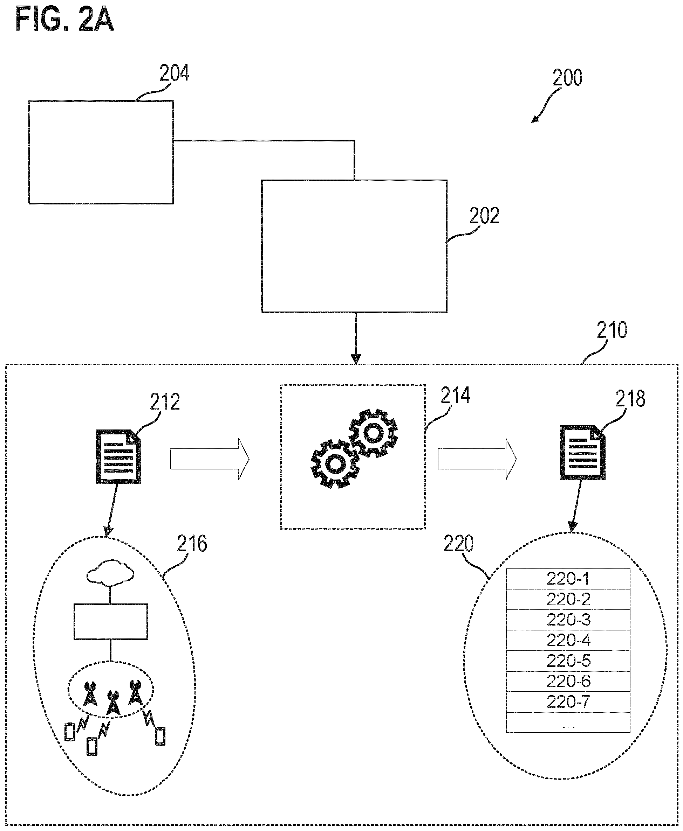

**FIG.2A** shows a device 200 for use in a wireless network (e.g., in the wireless network 100, e.g. in a heterogeneous wireless network including cells and/or network access nodes of different types) in a schematic representation according to the present disclosure. As an exemplary configuration, the device 200 may be for use in a 5G wireless network. The device 200 may be configured to implement a dynamic approach for selecting a configuration of network components. The device 200 may be configured for deployment at various locations within the wireless network, e.g. within a radio access network, for example at a network access node (e.g., eNodeB, gNodeB) and/or at a controller of the wireless network (e.g., at a RAN intelligent controller, for example near-real time RIC or non-real time RIC). As an example, a network access node (e.g., the network access node 104, 196 described in relation to FIG. 1A to FIG.1D, e.g. a network access node of an ORAN architecture) may include the device 200. For example, a base station (e.g., eNodeB, gNodeB) may include the device 200. It is however understood that also other entities within a wireless network may include a device 200 as described herein, e.g. a core network node (e.g., a network controller) may include the device 200, as another example. An entity including the device 200 may be understood, for example, as the operation described in relation to the device 200 running at that entity (e.g., in a host, in a processor, or in a plurality of processors, at that entity). It is also understood that the operation of the device 200 (e.g., of a processor 202 of the device 200) may be distributed among more than one network entity, e.g. among a plurality of entities (e.g., nodes and/or units) present in the wireless network and/or communicatively coupled with the wireless network (e.g., in a cloud-environment). As an exemplary configuration, the device 200 may be a module or a node for deployment in a wireless network. It is understood that the representation of the device 200 may be simplified for the purpose of illustration, and the device 200 may include additional components with respect to those shown. The device 200 may be referred to herein as RAN system prediction block.

The device 200 may include a processor 202 configured to select a configuration of the operation of one or more network components based on a network environment. The processor 202 may be configured to select the configuration of the one or more network components based on the output 218 of a trained machine learning model 214, e.g., to find a configuration providing power savings and reasonable network performance. By way of illustration, the processor 202 may be configured to carry out a method 210 of selecting a configuration of one or more network components, as described in further detail below. The trained machine learning model 214 may run at the processor 202, or may run at a different entity communicatively coupled with the processor 202 (e.g., may run in a cloud-environment).

To select the configuration of the one or more network components, the processor 202 may be configured to provide input data 212 to a trained machine learning model 214. The input data 212 may describe a network environment 216 of the wireless network, e.g. may be representative of a network environment 216 for which a configuration of the one or more network components may be selected. The input data 212 may thus be representative of information on wireless communication at the wireless network, e.g. at a given time point. Illustratively, the network environment 216 that the input data represents may include features characterizing wireless communication at the wireless network (e.g., at a cell of the wireless network, e.g. at a network access node of the wireless network), e.g. may include one or more characterizing features of the (current) operation of the wireless network.

The input data 212 (also referred to herein as input 212) may include data available from various entities of the wireless network, e.g. available from wireless communication devices, network access nodes, cells, etc. Illustratively, the input data 212 may include information from one or more entities participating in wireless communications at the wireless network. In general, the input data 212 may include user data, network access node data, cell data, sensor data, environment data (e.g., to describe a time of day, a weather condition, etc.), etc., and/or combinations thereof.

As examples, the network environment 216 that the input data 212 describes may include (illustratively, the input data 212 may be representative of one or more of): load information; traffic volume; type of traffic; cell configuration; average cell capacity; latency; network access time; throughput; time of day; day and/or month; season of the year; wireless device capabilities; network planning and deployment strategy; and/or combinations thereof. These characterizing features have been found to provide an effective characterization of a wireless network for the dynamic selection of the configuration of network components. It is however understood that these characterizing features are exemplary, and a network environment may include additional, less, or alternative characterizing features of the wireless network.

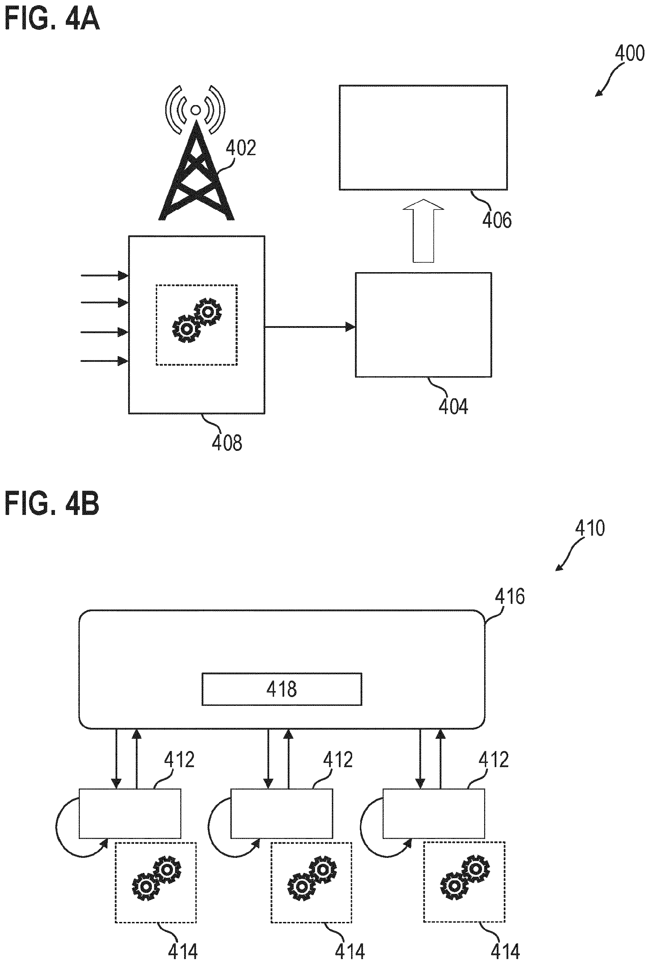

As an exemplary configuration, the input data 212 may include telemetry data from a plurality of cells of the wireless network and/or from a plurality of network access nodes of the wireless network. Illustratively, the input data 212 may include a collection of local data from cells and/or network access nodes (e.g., base stations) of the wireless network, e.g. describing a plurality of local operation scenarios of the wireless network (see also FIG.4B). The telemetry data may represent a plurality of partial network environments (e.g., a partial network environment may include features characterizing wireless communication at a cell, or at a network access node).

The trained machine learning model 214 may be configured to provide, based on the input data 212 (illustratively, based on the network environment 216), output data 218 representative of an expected (e.g., estimated, or forecasted) performance of a plurality of configurations of one or more network components with respect to power consumption and performance of the wireless network (in the given network environment 216). The output data 218 (also referred to herein as output 218) may represent a prediction of the trained machine learning model 214 with respect to the effects that applying the plurality of configurations 220 may have on power consumption and quality of communication at the wireless network. In the exemplary representation in FIG.2A the plurality of configurations 220 is shown to include seven configurations 220-1, 220-2, 220-3, 220-4, 220-5, 220-6, 220-7, but it is understood that the plurality of available (predefined) configurations 220 is scalable to any amount, e.g. two, three, four, five, ten, or more than ten.

The output data 218 of the trained machine learning model 214 may have any suitable representation (for processing at the processor 202). As an example, the output data 218 may include a plurality of scores (e.g., a plurality of numerical values). Each score of the plurality of scores may represent an expected (e.g., estimated, or forecasted) performance of a respective configuration 220 of the plurality of configurations 220 of one or more network components with respect to power consumption and performance of the wireless network in the network environment 216. Illustratively, the output data 218 may represent the plurality of configurations 220 each with an associated score describing an expected performance of that configuration 220 in the given network environment 216. A score of a configuration 220 may represent a rating (high-low) of which configuration 220 to pick (from the plurality of available configurations 220), based on the dynamic conditions that the network environment 216 represents, such as cell load, cell configuration etc. Illustratively, the expected performance of a configuration of the plurality of configurations 220 may be a performance of the wireless network in terms of one or more communication-based metrics (e.g., one or more of throughput, latency, coverage, etc.) and one or more energy-based metrics (e.g., one or more of power consumption, CPU cycles, compute complexity, etc.) in the case that the network component(s) is/are configured to operate according to that configuration.

It is however understood that the output data 218 may express the expected performance of the plurality of configurations in ways other than a numeric value, for example in a graphic manner (e.g., with a color), with a string of text (e.g., "high", "medium", "low", and the like), etc.

The plurality of configurations 220 of the one or more network components may be associated with a plurality of power saving mechanisms of the wireless network (illustratively, a plurality of possible strategies for reducing power consumption at the wireless network). The plurality of configurations 220 may thus be or include a plurality of predefined configurations for the operation of the one or more network components that are known to provide a reduction in the power consumption of the wireless network (according to a respective mechanism). Illustratively, a configuration of the plurality of configurations 220 may be an operating configuration of the one or more network components associated with a (respective) power saving mechanism. The plurality of configurations 220 may each describe a configuration of the same network components, or different configurations may describe a configuration of different network components. For example, the plurality of configurations 220 may include a first configuration 220-1 of one or more first network components, and a second configuration 220-2 of one or more second network components, with at least one second network component not being part of the first network components and/or with at least one first network component not being part of the second network components.

As described above, the one or more network components may include one or more (hardware and/or software) components of the wireless network associated with wireless communications. A configuration of the plurality of configurations 220 may thus be associated with respective wireless communication properties of the wireless network, e.g. with a respective data rate, beamforming configuration, bandwidth, periodicity, modulation, etc.

As examples, the plurality of configurations 220 may include two or more of: a configuration associated with an increase of system synchronization block periodicity; a configuration associated with a decrease of advertised bandwidth; a configuration associated with a variation of the bandwidth for each wireless communication device using a bandwidth part adaptation feature; a configuration associated with a use of a micro-discontinuous transmission technique on component carriers not used for initial access in a base station; a configuration associated with an increase of system information block periodicity; a configuration associated with a use of wake-up signaling features; a configuration associated with a use of discontinuous reception features; a configuration associated with an activation or deactivation of a carrier aggregation feature; a configuration associated with a secondary cell activation or deactivation; a configuration associated with a primary cell activation or deactivation; a configuration associated with a turning off of dual connectivity; a configuration associated with a turning off of pico cells or small cells while maintaining macro cells activated, or a turning off of macro cells while maintaining pico cells or small cells activated; a configuration associated with a turning off of a massive multiple-input multiple-output feature; a configuration associated with a deactivation or offloading of a machine learning computation associated with a function of a protocol stack; and/or combinations thereof. The practical implementations of such configurations may be known in the art, e.g. how to operate network components according to such configurations may be known in the art. The approach described herein is based on dynamically selecting which operating configuration of the network components to apply in the given network environment 216 rather than relying on static decisions. These configurations 220 have been found to provide an effective reduction of power consumed for wireless communications at a wireless network; it is however understood that the plurality of (available) configurations 220 may include additional, less, or alternative configurations for operations associated with reduced power consumption (associated with additional, less, or alternative power saving mechanisms).

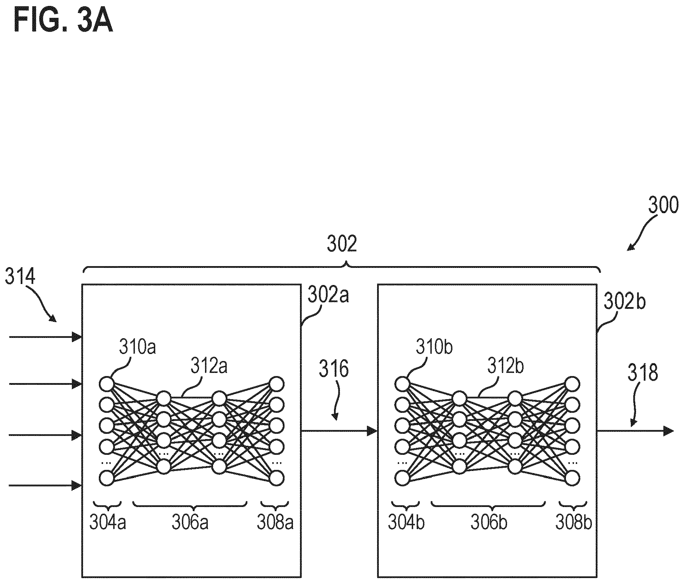

The trained machine learning model 214 may be configured to provide the output data 218 based on a combination of an expected reduction in power consumption and of expected performance metrics of communication at the wireless network associated with that configuration 220 (see also FIG.3A), e.g. based on an evaluation of one or more communication-based metrics and one or more energy-based metrics for each configuration. As an example, for each predefined configuration 220, the trained machine learning model 214 may be configured to determine (e.g., calculate, estimate, or forecast) the score for that configuration 220 by using the expected reduction in power consumption and the expected performance metrics.

The expected reduction in power consumption may be associated with one or more energy-based metrics, e.g. one or more energy-based key performance indicators, such as power consumed during sleep states, time duration, and/or the like. The one or more performance metrics may be representative of a performance of the wireless communication (illustratively, of a system performance), e.g. may include one or more communication-based metrics (one or more communication-based key performance indicators), such as throughput, latency, reliability, and/or the like. The trained machine learning model 214 may be configured to predict the one or more energy-based metrics and the one or more communication-based metrics, and to determine the expected performance (e.g., the score) of a configuration 220 based on the prediction. The trained machine learning model 214 may be configured to predict the one or more energy-based metrics and the one or more communication-based metrics at different timescales, for example corresponding to sleep state time scales.

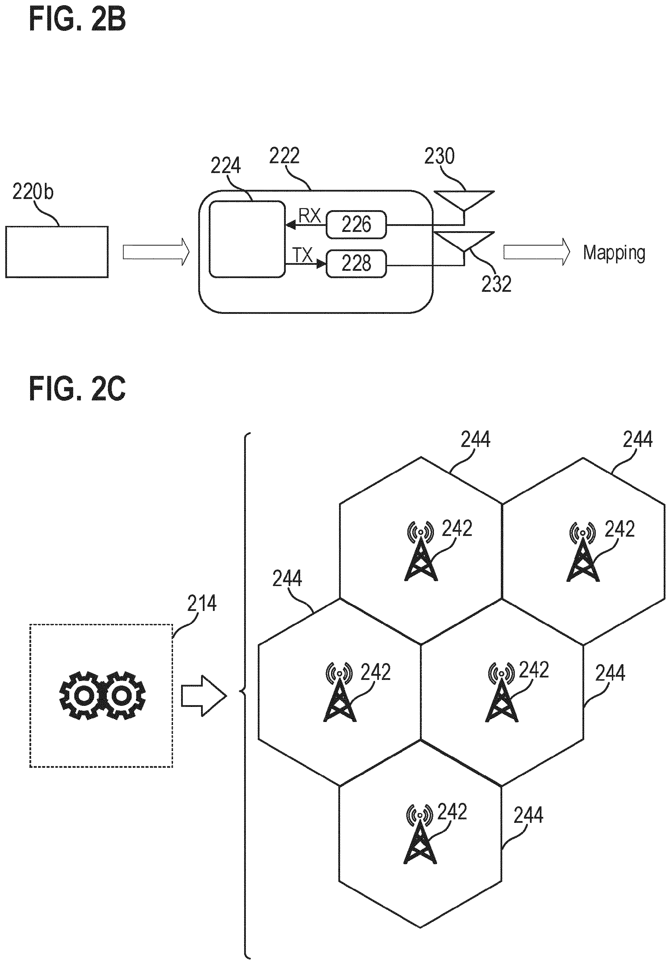

As an exemplary configuration, the trained machine learning model 214 may be further configured to provide the output data 218 (e.g., to determine the scores) based on one or more properties of the one or more network components (see also FIG.2B). The trained machine learning model 214 may be configured to provide the output data 218 based on (known) hardware (and/or software) capabilities of the one or more network components (e.g., the expected performance of a configuration may be associated with the capabilities of the one or more network components to be configured according to that configuration). Illustratively, the trained machine learning model 214 may be configured to take into consideration hardware and/or software constraints of the one or more network components (associated with each configuration 220) in providing the output data 218. For each power saving mechanism, the trained machine learning model may be configured to map a configuration at the system-level to the hardware and/or software configuration of the one or more network components (for example, the hardware and/or software configuration of a base station) to determine the resultant energy savings.

This configuration of the trained machine learning model 214 may provide coupling the platform capabilities that allow for actual power savings in the hardware of the actual network component(s) (e.g., in a base station) with the individual power saving mechanisms (associated with the predefined configurations 220). The trained machine learning model 214 may thus take the hardware capabilities of the network components into account. As an example, considering a base station, if the energy saving mechanism includes scaling down the operating bandwidth of the base station using component carriers not used for initial access, then such a mechanism may already be available at the hardware level and its power savings potential known a priori to the trained machine learning model 214.

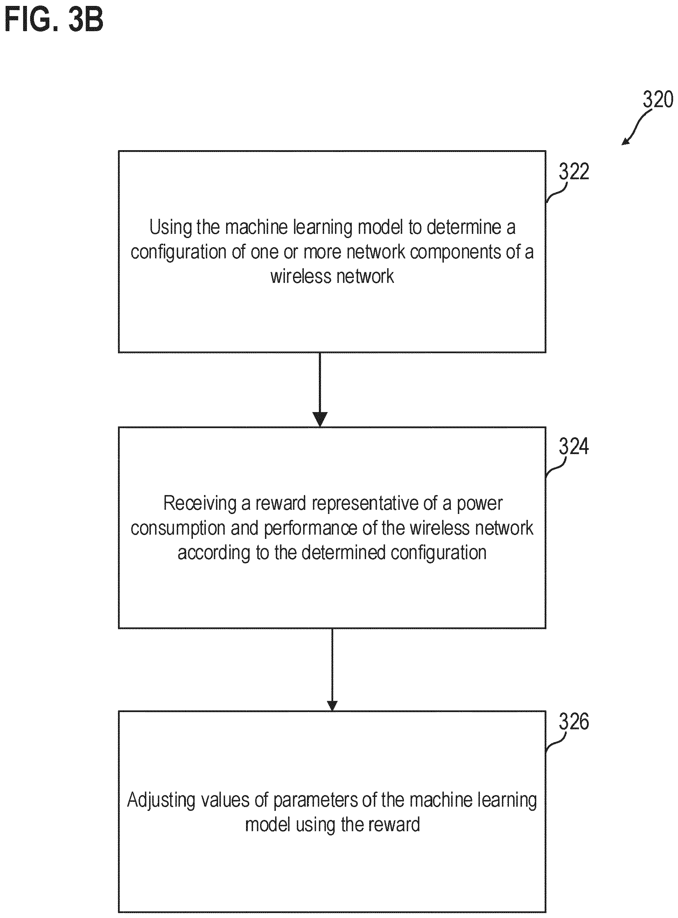

Considering the evolution of wireless communications, e.g. of the components of a wireless network (for example the hardware capabilities of a base station), more energy saving mechanisms (associated with more predefined configurations 220) may become available within the hardware as well as the mechanisms to configure them. The configuration of the device 200 described herein, as well as the configuration of the trained machine learning model 214 may be scaled such that as a new mechanism and hardware capability become mature, the machine learning model 214 may be trained to encompass the new capabilities of the wireless network. For example corresponding machine learning models for each new strategy may be trained separately over time. The training may be based on using a reinforcement learning (RL) agent configured to decide which model to use, given the input state (the input network environment) as traffic load, cell configuration, etc. The objective may be to maximize the long-term power saving and corresponding performance KPIs. The training of a machine learning model will be described in further detail below, see FIG.3A and FIG.3B.

An example is provided in **FIG.2B****,** which shows a mapping of a configuration 220b (providing a reduction in power consumption) to the hardware components of a network access node 222 (e.g., a base station) in a schematic representation according to the present disclosure. FIG.2B illustrates the mapping of a predefined configuration 220b (e.g., one of the predefined configurations 220 described in relation to FIG.2A) to its constituent power saving state on a network component associated with that configuration (e.g., the base station 222). As an example, the predefined configuration 220b may be associated with the power saving mechanism of increasing the Synchronization System Block (SSB) periodicity, which may provide lower power consumption on the radio frequency (RF) unit (e.g., including a RF Front-End for the receive path 226, e.g. analog and digital, and including a RF Front-End for the transmit path 228, e.g. analog and digital) and baseband processing unit 224 of the base station 222. The RF Front-End for the receive path 226 may be configured to provide at the baseband processing unit 224 a signal received at a receiving antenna 230 (or antenna array) of the base station 222. The RF Front-End for the transmit path 228 may be configured to provide at a transmit antenna 232 (or antenna array) of the base station 222 a signal from the baseband processing unit 224 for transmission.

The SSB may include synchronization signals such as primary and secondary synchronization signals and other important information that a wireless communication device (e.g., a user equipment) may first scan to be able to access the wireless network (e.g., a 5G system). In the case that there is very little traffic volume and the traffic is of such type that it does not require low latency services, a base station 222 (e.g., a 5G base station, a gNodeB) may reduce its energy consumption by reducing the SSB periodicity. The main components that are affected in this case are the RF transmission chain components and the baseband processing unit which is configured to perform the task of encapsulating the right information (e.g., physical cell ID and the like) within the signals. By enabling the capacity to change the periodicity of SSB transmission, the base station 222 may thus reduce energy consumption by sending such signals out less frequently. Conversely by reducing the energy spent, the base station 222 is also impacting its Key Performance Indicators (KPIs) for any wireless communication device that wishes to access the system as it takes longer for the wireless communication device to obtain the requested information.

The mapping may thus provide evaluating the power savings of changing the SSB periodicity taking into account the impact on Key Performance Indicators related to wireless communications at the base station 222 (e.g., in terms of throughput, latency, reliability, etc.). Such mapping may also be used in the framework of training the machine learning model 214, as discussed in further detail below.

Similarly, the other mechanisms may also be mapped to various power saving levels and their corresponding impact to KPIs for the base station 222 (or for a cell, as another example) as well as the hardware capabilities of the system itself. Thus, the trained machine learning model 214 may be configured to balance each energy saving mechanism among several factors such as the energy saved, the impact to the KPIs and the inherent hardware capability of the system hardware itself.

The device 200 described herein, with the trained machine learning model 214, may thus provide an answer to the question of which energy saving mechanism (and thus which predefined configuration 220) to apply under what conditions (e.g., for a given network environment). The trained machine learning model 214 may be configured to provide such answer based on the impact of the mechanisms on system energy consumption and communication performance, e.g. based on the existing cell load traffic volume, the type of traffic currently being used in the system and neighboring cells etc., which may allow for traffic to be offloaded to neighboring cells to reduce the total number of active cells in the system. As an exemplary scenario, since there may generally be more than one cell to provide service to a particular user, the trained machine learning model 214 may determine (as preferred) a configuration 220 including pushing a particular cell in sleep state experiencing less traffic load, and offloading the traffic on other co-located cells, to save system power, or offloading traffic from cells operating at high frequency (and turn them off) to cells operating at lower frequency but covering larger area, etc.

The device 200 described herein, with the trained machine learning model 214, may thus provide a flexible and dynamic selection of which operating configuration to apply for one or more network components based on energy-based and communication-based metrics for the given network scenario 216. The flexibility provided by the approach described herein is particularly relevant in the context of heterogeneous networks, where mechanisms for saving power may be vendor/version/configuration specific, so that it may be inefficient to apply same power model to all cells in the network as they operate in heterogeneous environment changing in space and time.

The processor 202 may be further configured to instruct a configuration 220 of the one or more network components based on the output data 218 of the trained machine learning model 214. Illustratively, the processor 202 may be configured to select a configuration of the plurality of (predefined) configurations 220 based on the output data 218, e.g. based on the plurality of scores. The processor 202 may be configured to select the configuration having associated therewith the expected performance with greater reduction in power consumption and/or greater performance of the communication at the wireless network compared to the other configurations 220 (e.g., greater throughput, lower latency, etc.). As an example, the processor 202 may be configured to select the configuration having the greatest score among the plurality of configurations 220.

The processor 202 may be configured to instruct an operation of the one or more network components (associated with the selected configuration) based on the selected configuration. The processor 202 may be configured to transmit a respective instruction to the one or more network components to which the selected configuration 220 applies. The instruction may be representative of an operation of a network component according to the selected configuration 220, e.g. may be representative of how to operate the network component to provide the selected configuration 220 (see also FIG.4A). In an exemplary configuration, the processor 202 may be configured to transmit an instruction including the selected configuration 220 to a further entity of the wireless network, e.g. to a manager of the one or more network components configured to control the one or more network components.

In an exemplary configuration, the processor 202 may be configured to apply the configuration 220 of the one or more network components based on the output data 218 of the trained machine learning model 214, e.g. may be configured to apply the selected configuration 220. The processor 202 may be configured to control the one or more network components according to the selected configuration 220.

The description of the operation of the processor 202 in FIG.2A has been illustrated in relation to a trained machine learning model 214. It is however understood that more than one trained machine learning model 214 may be available for selecting a configuration 220 of the one or more network components. The processor 202 may be configured to select the trained machine learning model 214 from a plurality of trained machine learning models. Illustratively, the processor 202 may be configured to select which trained machine learning model to use for selecting the configuration 220 of the one or more network components.

The plurality of trained machine learning models may include machine learning models configured (e.g., trained) for respective network environments, e.g. the plurality of trained machine learning models may include a machine learning model for a high load environment, a machine learning model for a low traffic environment, a machine learning model for a high interference environment, etc., as examples. For example, the processor 202 may be configured to select the trained machine learning model dependent on the (current) network environment 216. Illustratively, the processor 202 may be configured to select the trained machine learning model based on the input data 212, e.g., according to the network environment 216 that the input data 212 represents. This may provide modelling the power consumption and the communication performance of the wireless network using a corresponding machine learning model for the particular scenario, which may increase the accuracy of the estimation.

In an exemplary configuration, the device 200 may further include a memory 204 storing instructions and/or data for the processor 202. The memory 204 may be communicatively coupled with the processor 202 (e.g., via a wired or wireless connection). The memory 202 may be disposed at a same entity as the processor 202 (e.g., at a same network access node) or may be disposed at another entity (e.g., another network access node, or another node in the wireless network, or in a cloud-environment, as examples), e.g. in the context of a distributed system. The memory 204 may store instructions to perform the selection of a configuration of network components. For example, the memory 204 may store the trained machine learning model 214 (e.g., the plurality of trained machine learning models). As another example, additionally or alternatively, the memory 204 may store the predefined configurations 220 of the network components, e.g. may store corresponding instructions on how to operate the network components according to the predefined configurations 220. As a further example, additionally or alternatively, the memory 204 may store the input data 212 provided to the trained machine learning model 214 and/or the output data 218 that the trained machine learning model 214 provides. Illustratively, the memory 204 may store the input data 212 representative of the network environment 216 and/or may store the output data 218 representative of the expected performances of the plurality of predefined configurations 220.

In an exemplary configuration, the processor 202 may be configured to update the machine learning model 214 (e.g., each machine learning model of the plurality of machine learning models), e.g., to adjust parameters of the machine learning model 214 via learning techniques (see also FIG.3A and FIG.3B). Illustratively, the processor 202 may be configured to automatically configure the machine learning model 214 based on feedback on the performance of the model, e.g. feedback on the performance of a configuration selected using the machine learning model 214.

**FIG.2C** shows an exemplary application scenario for the approach described herein in a schematic representation according to the present disclosure.

As an exemplary configuration, the approach described herein may be applied at cell-level, or network access node-level (e.g., base station-level). The trained machine learning model 214 may be representative of one or more network access nodes 242 of the wireless network, e.g. the trained machine learning model 214 may be configured (e.g., trained) based on data available at the one or more network access nodes 242 and may be configured to evaluate (e.g., assign scores to) configurations applicable at the one or more network access nodes 242. The trained machine learning model 214 may be configured to model power savings and performance at the one or more network access nodes 242. Illustratively, the one or more network components may be or include one or more network components of a network access node 242 (e.g., of one or more network access nodes 242), such as RF transceiver, antenna, baseband processing unit, processing functions at a network access node, and the like. The one or more network access nodes 242 may be of a same type (e.g., may be pertaining to a same radio communication technology) or may be of different types (e.g., a first network access node 242 may pertain to a first radio communication technology, e.g. may be a eNodeB, and a second network access node 242 may pertain to a second radio communication technology, e.g. may be a gNodeB, as an example).

The one or more network access nodes 242 may be associated (e.g., may define) one or more cells 244 of the wireless network. Illustratively, the one or more network access nodes 242 may provide coverage at one or more cells 244 of the wireless network. The trained machine learning model 214 may thus be representative of one or more cells 244 of the wireless network, e.g. the trained machine learning model 214 may be configured (e.g., trained) based on data available at the one or more cells 244 and may be configured to evaluate (e.g., assign scores to) configurations applicable to the one or more cells 244. The trained machine learning model 214 may be configured to model power savings and performance at the one or more cells 244. Illustratively, the one or more network components may be or include one or more network components of a cell 244 (e.g., of one or more cells 244), such as a control function for data rata at a cell 244, a handover function for inter-cell and/or intra-cell handover, and the like. The one or more cells 244 may be of a same type or may be of different types (e.g., a first cell 244 may be a macro cell and a second cell 244 may be a micro cell, as an example).

It is understood that the representation in FIG.2C is exemplary in relation to the number of network access nodes 242, the number of cells 244, and the disposition/configuration of the network access nodes and cells. The number of network access nodes 242 and cells 244 may be scalable to any amount, for example to any number of network access nodes 242 within a same geographical area (such as in the neighborhood of a same site, like a stadium, a concert hall, etc.). The shape of a cell 244 is shown as hexagonal but it is understood that a cell 244 may have any suitable shape as defined by the coverage of the associated network access node(s) 242, and adjacent cells 244 may also overlap with one another (there may be overlapping coverage). It is also understood that a cell 244 may include more than one network access node 242 (e.g., may include network access nodes of different types).

The selection of a configuration at cell-level or network access node-level may provide taking into account local differences in the environment of the wireless network, thus providing targeted configurations to adapt to the different local network scenarios.

The trained machine learning model 214 may thus be configured (e.g., trained) to provide the output data 218 taking into consideration network access node-specific and/or cell-specific metrics, in addition or in alternative to the metrics discussed in relation to FIG.2A. Such network access node-specific and/or cell-specific metrics may be considered during the training of the machine learning model as well as during the inference by the machine learning model. Illustratively, the input data 212 may include the network access node-specific and/or cell-specific metrics discussed in further detail in the following, and/or the machine learning model 214 may be (already) trained to take such metrics into consideration.

As an example, additionally or alternatively to the parameters mentioned in relation to FIG.2A, the input data 212 may include (e.g., may be representative of) one or more of: a deployment topology in proximity of the one or more network access nodes 242, a radio access technology of a network access node 242, a radio access technology of a network access node in relation to the radio access technology of another network access node 242, and/or combinations thereof. The trained machine learning model 214 may be configured to provide the output data 218 based on one or more of such metrics. Illustratively, network access nodes 242 (e.g., base stations) with different radio access technologies (e.g., LTE, NR, etc.) may have different power consumption. As a further example, additionally or alternatively, the input data 212 may include (e.g., may be representative of) one or more of: a configuration of the one or more cells 244, a deployment topology in proximity of the one or more cells 244 (e.g., macro cell/ micro cell /small cell overlay deployment), and/or combinations thereof. The trained machine learning model 214 may be configured to provide the output data 218 based on one or more of such metrics.

The predefined configurations 220 of the one or more network components may include, additionally or alternatively to the configurations discussed in relation to FIG.2A, one or more network access node-specific and/or cell-specific configurations, e.g. one or more configurations associated with power savings at a network access node 242 and/or at a cell 244. As examples, the plurality of (predefined) configurations 220 may include, additionally or alternatively to the configurations discussed in relation to FIG.2A, one or more of (e.g., two or more of): a configuration associated with pushing one cell of the one or more cells 244 in sleep state; a configuration associated with offloading traffic from one cell of the one or more cells 244 onto another cell of the one or more cells 244; and/or a configuration associated with offloading traffic from one cell of the one or more cells 244 operating at a first frequency onto another cell of the one or more cells 244 operating at a second frequency lower than the first frequency.

In a further exemplary configuration, additionally or alternatively, the trained machine learning model 214 may be configured (e.g., trained) to provide the output data 218 taking into consideration one or more properties of wireless communication devices (e.g., user equipment) that a network access node 242 serves, e.g. one or more wireless communication devices in a cell 244 of the wireless network. The one or more properties of the wireless communication devices may influence the configuration(s) that may be selected for the network access node 242 that serves the wireless communication devices, e.g. for the cell 244 in which the wireless communication devices are located. In this regard, the input data 212 may include, additionally or alternatively, data representative of wireless communication devices that a network access node 242 serves, such as a type of network access node that a wireless communication device may support, a type of wireless communication device, and/or the like.

The trained machine learning model 214 may thus be configured (e.g., for inference and training) to provide the output data 218 based on UE capabilities. As examples, in case the wireless communication devices include limited function devices, such as machine-type communication (MTC) devices, or include devices with very advanced capabilities, this may limit the possible options that a network access node (a base station) may deploy for energy savings. As a further example, a network access node with wake-up radio (WUR) may be prioritized to send to sleep states as it may be awakened if a wireless network becomes active in the network access node. Capabilities of current active UEs may also be crucial to select energy power saving options. For example, if some UEs support BS-type1 (e.g., LTE BS) only, while other UEs support both BSs (e.g., LTE and NR BSs), then sending LTE BS to sleep may not be an option, i.e., sending NR BS may be prioritized in such case.

In an exemplary configuration, a collaboration group among one or more network access nodes 242 (e.g., among proximate base stations) may be considered. A collaboration group may include a plurality of network access nodes 242 (e.g., of a same operator or of different operators, for example operators having a shared incentive) collaborating together for power savings. Illustratively, the plurality of (predefined) configurations 220 may include at least one configuration associated with a group power saving of a plurality of network access nodes 242. The at least one configuration may include a plurality of respective configurations of the plurality of network access nodes 242 of the collaboration group, which collectively provide a reduced power consumption (and reasonable communication performance).

The trained machine learning model 214 may be configured, additionally or alternatively, to provide the output data 218 based on an interaction among the plurality of respective configurations of the plurality of network access nodes 242. In this regard, the input data 212 (for inference and/or training) may include information shared among the plurality of network access nodes 242 of the collaboration group. Illustratively, the network access nodes in the group may share information (such as current cell traffic load, number of users, user-types, traffic characteristics, capabilities of users, etc.) helpful to decide which network access node should take which action to maximize group power saving, rather than maximizing power/energy savings at individual network access node-level. One network access node of the group, or some centralized entity in the network, may be configured as orchestrator (in other words, leader) of the group.

Usually, cells 244 from different operators may have high overlapping coverage. Thus, a collaboration group including network access nodes of different operators, e.g. a collaboration group for energy saving across operators, may provide maximizing turning off a significant portion of cells with offloading users/traffic across operators. For examples, operators may have a prior agreement to share the incentive (gain in energy saving) to maximize collective energy saving specifically when the traffic load is not at peak. The orchestrator may include an AI/ML module to initiate formation of such collaboration groups once certain criteria are met (e.g., when load on cells in average drops below a threshold, as an example).

In an exemplary configuration, the processor 202 may be further configured to define a collaboration group including a plurality of network access nodes of the wireless network (a group for collective power savings), and may be configured to provide input data 212 at the trained machine learning model 214 representative of a network environment 216 of the collaboration group. Illustratively, the processor 202 may be configured as orchestrator, or as another example the processor 202 may be communicatively coupled with the orchestrator of a collaboration group.

**FIG.3A** shows a machine learning model 300 in a schematic representation, and **FIG.3B** shows a schematic flow diagram of a method 320 of training a machine learning model according to the present disclosure. The machine learning model 300 may be an exemplary configuration of the machine learning model 214 described in relation to FIG.2A to FIG.2C. The method 320 of training a machine learning model may be an exemplary configuration of a method of training the machine learning model 214 described in relation to FIG.2A to FIG.2C (illustratively, the machine learning model 214 may be trained according to the method 320).

As an exemplary configuration, as shown in FIG.3A, the machine learning model 300 may be or include a deep learning model, e.g. may be or include a neural network 302 (an artificial neural network, ANN). A neural network has been found as a suitable architecture of a machine learning model to implement the dynamic approach for selecting a configuration of network components described herein. It is however understood that a machine learning model (e.g., the machine learning model 214, 300) may be or include any type of machine learning model suitable for modelling the expected performance of a configuration of one or more network components in a given network environment, e.g. a regression model, a classification model, a clustering model, etc., as other examples, including a deep learning model or not including a deep learning model. Thus, the following discussion may apply in a corresponding manner to other types of machine learning models.

It is also understood that the configuration of the neural network 302 described in relation to FIG.3A is an exemplary configuration that has been engineered for the task of dynamic selection of the configuration of network components, but the neural network 302 may also have other configurations, e.g. with a different number of nodes, different number of layers, different connections between nodes, etc. It is also understood that the representation of the neural network 302 in FIG.3A is for illustration purposes, and may not correspond to an actual architecture of the neural network 302.

The machine learning model 300 may include a first prediction portion and a second prediction portion (also referred to herein as a first prediction model and a second prediction model), e.g. a first (partial) machine learning model and a second (partial) machine learning model. In the configuration in FIG.3A, the neural network 302 may include a first neural network 302a and a second neural network 302b. The first prediction portion and the second prediction portion may be related to one another in such a way that the output data of the first prediction portion may be the input data of the second prediction portion (e.g., the output data of the first neural network 302a may be the input data of the second neural network 302b). The machine learning model 300 may thus provide a two-stage neural network mapping of a power state mechanism to actual energy saving state on a network component (e.g., on a base station). The first prediction portion and the second prediction portion may include a same type of machine learning model, or may include different types of machine learning models.

As known in the art, a neural network (e.g., the first neural network 302a and the second neural network 302b) may include an input layer 304a, 304b, an output layer 308a, 308b, and one or more hidden layers 306a, 306b between the input layer 304a, 304b and the output layer 308a, 308b. Each layer may include one or more nodes 310a, 310b, and nodes in adjacent layers may be connected with each other via corresponding connections 312a, 312b. A node 310a, 310b in a layer may be connected with each node in a subsequent layer, or only with a subset of nodes in the subsequent layer. The connections 312a, 312b among nodes 310a, 310b are weighted connections, whose weights may be adjusted, e.g. during training and/or learning of the neural network 302.

The prediction portions of the machine learning model 300 (e.g., the first neural network 302a and the second neural network 302b) may be associated with different parts of the selection of the configuration of network components. Illustratively, the problem of finding a configuration to apply may be split into two partial problems, one related to evaluating which power saving mechanism may be most suitable in a given network environment, and the other related to which configuration of network components may be most suitable for the selected power saving mechanism.

Illustratively, the first prediction portion (the first neural network 302a) may be configured to receive input data 314 representative of a network environment, and may be configured to provide (first) output data 316 representative of power saving mechanism(s) of the wireless network. The input data 314 may be configured as the input data 212 described in relation to FIG.2A, for example including a traffic load, cell configurations, hardware and/or software capabilities of a network access node, a latency, a throughput, a network access time, etc. The output data 316 may be representative of an expected performance of a plurality of power saving mechanisms in the given network environment. As an example, the output data may include a plurality of scores (e.g., the contents of the nodes of the output layer 308a of the first neural network 302a), each score associated with a respective power saving mechanism of a plurality of power saving mechanisms. A score may be representative of an expected performance (an expected effect) of the respective power saving mechanism in the given network environment, e.g. may be representative of an expected reduction in power consumption provided with the respective mechanism in the given network environment. As an exemplary configuration, the output data 316 may be representative of a single power saving mechanism, predicted to have the greatest expected performance (e.g., the greatest reduction in power consumption) in the given network environment

The second prediction portion (the second neural network 302b) may be configured to receive as input data the output data 316 of the first prediction portion, e.g. input data representative of an expected performance of a plurality of power saving mechanisms in the given network environment, e.g. input data representative of the power saving mechanism having the greatest expected performance in the given network environment. The second prediction portion (the second neural network 302b) may be configured to provide (second) output data 318 representative of configuration(s) of one or more network components of the wireless network. The output data 318 may be configured as the output data 218 described in relation to FIG.2A, e.g. including a plurality of scores (e.g., the contents of the nodes of the output layer 308b of the second neural network 302b) each associated with a configuration of a plurality of configurations of network components. The output data 318 may be representative of the configuration of network components providing the greatest expected performance of the wireless network (among the possible configurations) for the power saving mechanism selected with the first prediction portion. Illustratively, the output data 318 of the second prediction portion may be representative of the operating configuration of network components that provides the greatest communication performance (e.g., greatest throughput, lowest latency, lowest interference, etc.) for implementing the power saving mechanism indicated by the output data 316 of the first prediction portion.

By way of illustration, the first prediction portion (the first neural network 302a) may be used to search for the power state best served under various cell load conditions and then serve it to another prediction portion (the second neural network 302b) which could then use this power state to map to the actual mechanism to save energy. The first prediction portion may be used to make a decision using a multi-objective function which may maximize the KPIs and minimize the energy consumption and output the power saving mechanism which would help achieve the objective. This power saving mechanism may then be fed into another prediction portion (the second neural network 302b) as an example to output the exact state, for example power state level 0.

FIG.3B shows a flow diagram of a method 320 of computer-implemented training a machine learning model used for selecting a configuration of one or more network components of a wireless network according to the present disclosure. A processor (e.g., the processor 202) may be configured to train a machine learning model according to the method 320. In general, the training may be supervised or unsupervised. As an example, training of the machine learning model may include reinforcement learning techniques, as discussed in further detail below. The method 320 may be for training the machine learning model 214, 300 described in relation to FIG.2A to FIG.3A.

The method 320 may include, in 322, using the machine learning model to determine (e.g., to select) a configuration of one or more network components of a wireless network (e.g., a configuration of the plurality of predefined configurations 220). The method 320 may include, in 324, receiving a reward representative of a power consumption and performance of the wireless network according to the determined configuration (e.g., a reward representative of a quality of power saving and communication-performance). The method 320 may include, in 326, adjusting values of parameters (e.g., weights) of the machine learning model using the reward.

By way of illustration, the method 320 may include using the machine learning model to determine how the one or more network components should operate, and adjusting the machine learning model based on the quality of the configuration determined with the model.

Using the machine learning model to determine a configuration of one or more network components, 322, may include providing to the machine learning model input data representative of a network environment, generating output data representative of an expected performance of a plurality of configurations of one or more network components with respect to power consumption and performance of the wireless network (e.g., the plurality of configurations 220 described in relation to FIG.2A to FIG.2C), and selecting a configuration based on the output data. The selected configuration may also have a predicted performance score associated therewith.

Then, the method 320 may include operating the one or more network components according to the selected configuration, e.g. may include performing wireless communication according to the selected configuration. For example, the training may be carried out in a test wireless network with test network components (e.g., with known properties, known interactions, etc.). As another example, operating the one or more network components may include simulating wireless communication (e.g., communication performance and power consumption) based on the selected configuration, e.g. with a computer.

Receiving a reward representative of a power consumption and performance of the wireless network according to the determined (e.g., selected) configuration, 324, may include, for example determining (e.g., calculating, or estimating) a reduction in power consumption and a quality of wireless communication for network components operating according to the selected configuration. The reward may be, for example, based on a difference between the power consumption and quality of wireless communication associated with the selected configuration and target data (e.g., a target reduction in power consumption and/or a target quality of wireless communication). As another example, the reward may be based on a difference between the configuration defined by the machine learning model and a target configuration (known to be the most suitable in the given network environment).

As an exemplary configuration, the reward may be based on the output of a further machine learning model. The further machine learning model (e.g., a further neural network) may receive as input data a detailed accounting of each power saving mechanism, and may provide as output data a target reduction in power consumption and a target quality of wireless communication for each power saving mechanism. The method 320 may include using the further machine learning model to train the machine learning model (e.g., to train the neural network).

Adjusting values of parameters of the machine learning model using the reward, 326, may include adjusting learnable weights of the machine learning model (e.g., weights of the connections among nodes of a neural network, e.g. of the first neural network 302a and/or the second neural network 302b). Illustratively, the training may include adjusting the parameters with the aim of increasing (e.g., maximizing) the reward, e.g. with the aim of providing a configuration with power saving and quality of communication greater than or equal to the target data. The method 320 may include adapting the weights (also referred to herein as weighting factors) such that the predicted performance score for the selected configuration is increased.

An exemplary configuration of the method 320 considering a two-stage machine learning model (e.g., a two stage neural network) may be as follows. Illustratively, the method 320 may be split into a first training of a first prediction portion and a second training of a second prediction portion of the machine learning model. The method may include providing to a first prediction portion of the machine learning model first input data describing a network environment to generate a power state vector describing, for each power saving mechanism of a plurality of power saving mechanisms, a power state of one or more network components with associated first predicted performance score. Each power state may a combination of individual power states of the one or more network components weighted by first weighting factors. The method may further include training the first prediction portion of the machine learning model by adapting the first weighting factors based on first target data in which a power state of the one or more network components is associated with a quality parameter above a predefined threshold, such that the first predicted performance score for the power state is increased. The quality parameter may be representative of one or more communication-based metrics, such as a throughput, a latency, a reliability, a quality of service of the wireless network and/or combinations thereof. Illustratively, the quality parameter may be representative of how a power saving configuration affects wireless communication in the given scenario.

As an example, the first input data may include telemetry data from one or more network access nodes (and/or one or more cells) of the wireless network, e.g. the telemetry data may include one or more of: cell traffic load; cell configuration of one or more cells in an area of interest; cell configuration of one or more cells in an area neighboring an area of interest; hardware information of the plurality of network components (e.g., network components of the network access nodes); and/or one or more key performance indicators (e.g., latency, throughput, network access time, and the like).

The method may further include providing to a second prediction portion of the machine learning model second input data (e.g., based on the power state vector generated with the first prediction model) describing a plurality of power states of the one or more network components to generate, for each power state, a configuration vector describing a configuration of the one or more network components with associated second predicted performance score. Each configuration may be a combination of individual configurations of the one or more network components weighted by second weighting factors. The method may further include training the second prediction portion of the machine learning model by adapting the second weighting factors based on second target data in which a configuration of the one or more network components is associated with a power savings parameter above a predefined threshold, such that the second predicted performance score for the configuration is increased. The power savings parameter may representative of one or more energy-based metrics, such as a sleep power, a sleep time, and/or an exit latency from a sleep power level of the plurality of network components, and/or combinations thereof. As an exemplary configuration, the power savings parameter may be representative of a percentage of power saved by a configuration of the one or more network components with respect to a configuration in which each network component is operating at full capacity. Illustratively, the power savings parameter may be representative of how a configuration of network components implements the given power saving configuration in the given scenario.

As noted earlier, system energy saving mechanisms such as cell activation/deactivation may impact quality of service (QoS) for the connected users/services. Thus, user activity may be a parameter for training a machine learning model (e.g., the machine learning model 214, 300). The method 320 may include monitoring user activity and correlating user activity to the network environment and to the configuration of network components. User activity may include, as examples, establishing and ending calls/connections, the QoS requirements of the flows within those connections, user mobility etc., especially with the time of the day and certain events and locations. These information may be available at various entities of a wireless network. As examples, this information may be based on one or more of: data from a macro base station with a plurality of small cells; data across a plurality of macro base stations and a plurality of small cells; data from a Centralized Radio Access Network system; and/or data from a plurality of Centralized Radio Access Network systems. This information can be then applied to making decisions on which component within the system should be turned on/off for the most system energy savings. In the context of method 320, the reward may include the information on user activity. Furthermore, the method 320 may include determining the quality parameter (for training of the first prediction portion) based on the information on user activity.

As a further exemplary configuration, a method of training a machine learning model (e.g., the machine learning model 214, 300) may be based on reinforcement learning techniques. Illustratively, the processor 202 may be configured to use reinforcement learning to adapt the machine learning model 214. In this regard, the processor 202 may be configured as a RL agent, or the device 200 may include a RL agent.

The concept of "reinforcement learning" may be known in the art. In brief, reinforcement learning may include an agent and an environment, and the agent may take actions to interact with the environment. Based on the actions taken, the agent may receive a positive reward, so that the agent may learn which actions lead to obtaining the reward and which actions instead do not. The agent may design a policy to define which actions (a) to take, given a state (s) of the environment, to maximize the chances to get a (future) reward (R). The selection of an action in a given state may be probabilistic, to take into account for the probabilistic rather than deterministic nature of the environment. Reinforcement learning may be based on different strategies, such as differential programming, Monte Carlo, Temporal Difference, etc.

In the context of the present disclosure, the agent may be the processor 202 of the device 200 or may be part of the device 200, the state of the environment may be the network environment, the actions may be the selection of a certain configuration of the operation of the network components to provide power saving, and the rewards may be associated with the power consumption and the performance of the wireless network with the selected configuration(s).

Learning may be implemented in a centralized manner and/or a distributed manner, as described in further detail in relation to FIG.4A and FIG.4B.

**FIG.4A** shows a centralized learning environment 400 in a schematic representation according to the present disclosure. Centralized learning may include aggregating data from various entities of the wireless network (e.g., network access nodes, cells, etc.) at a centralized location, such as the O-Cloud or an orchestration and management (OAM) entity of the wireless network.

The aggregated data may be or include telemetry data, e.g. from a plurality of network access nodes of the wireless network. A network access node 402 may be configured to collect telemetry data and transmit the telemetry data to the centralized location of the wireless network, e.g., the Orchestration and Management (OAM) entity within 3GPP network or the O-Cloud within the ORAN framework. The data aggregated in the centralized location may be representative of the network environment and/or of the power saving and communication performance provided with a selected configuration for the operation of network components. The aggregated data may thus be used to train a machine learning model at the centralized location, e.g. offline. The model(s) trained at the centralized location may then be deployed at the individual network access nodes 402 for inference to make decisions regarding energy savings. In this context, the training may or may not take into consideration the individual hardware capabilities of the network access nodes.

As shown in FIG.4A, a processor 404 of the network access node 402 (e.g., configured for power management of the network access node 402, e.g. the processor 404 may be a local power management unit of the network access node 402) may be configured to receive a machine learning model 408 from a centralized location of the wireless network (e.g., the OAM, or the O-Cloud, as examples). Illustratively, the processor 404 may be configured to receive model parameters and functions for selecting an operating configuration at the network access node 402. The machine learning model 408 may be a trained machine learning model, e.g. configured as the machine learning model 214, 300 described in relation to FIG.2A to FIG.3B.

In this configuration, the individual model inference may be less specific to the actual capabilities of a given network access node and may only give an output of the power mechanism (rather than the specific configuration to apply at the network access node). The processor 404 may be configured to map the power saving mechanism output of the machine learning model 408 to the hardware components 406 of the network access node 402. Illustratively, the processor 404 may be configured to determine a configuration of the hardware (and/or software) components 406 of the network access node 402 according to the power saving mechanism that the output data of the machine learning model 408 represent. In this regard, as an example, the processor 404 may be configured to use a further machine learning model for the mapping.

By way of illustration, the machine learning model 408 received from the centralized location (also referred to herein as centralized model) may output the power mechanism that the network access node 402 (or a cell) should implement. The processor 404 may be configured to translate the power mechanism to specific hardware mechanisms depending on the capabilities of the network access node 402 (illustratively, depending on cell capabilities).

**FIG.4B** shows a distributed learning environment 410 in a schematic representation according to the present disclosure. While centralized training may provide better diversity of application for a given machine learning model to a variety of different scenarios, due to the sheer number of combinations of configurations that are possible within a wireless network (e.g., within a 5G system), the model may be prohibitively complex or unable to give good results for a variety of conditions where there is a slight divergence in local conditions.

Under such conditions, distributed learning techniques, such as federated learning or hierarchical federated learning, may provide scalability as well as better personalization options. In this scenario, instead of the telemetry data being aggregated at a centralized location, such as the OAM or the O-Cloud, a network access node may retain its telemetry data and train locally a respective instance of the machine learning model. The network access node may then share model parameters to obtain global models to take advantage of data diversity, but also train locally to personalize the model to local context.

Considering for example the scenario illustrated in FIG.4B, a plurality of network access nodes 412 (e.g., a plurality of gNodeB) may each include a respective machine learning model 414 (illustratively, a respective machine learning model 414 may run at each network access node 412 rather than being trained at a centralized location). The machine learning model 414 may be configured as the machine learning model 214, 300 described in relation to FIG.2A to FIG.3B. Each network access node 412 may thus be configured to use and train locally the respective machine learning model 414. Illustratively, a processor of a network access node 412 may be configured to use (and train) locally a machine learning model for selecting a configuration of the hardware/software components of the network access node 412 based on power consumption and performance of the communication at the network access node 412.

The network access nodes 412 (e.g., its processor) may be configured to transmit (only) model parameters of the respective machine learning model 412 (and may be configured to refrain from transmitting telemetry data), e.g. adapted via local training and/or learning, to a centralized location 416 of the wireless network. The centralized location 416 may be, for example, a radio access network intelligent controller of the wireless network, such as a non-real time RIC or a near-real time RIC. The centralized location 416 may include a processor 418 (e.g., a federated learning aggregator) configured to receive the model parameters from the network access nodes and to provide updated model parameters to the network access nodes (based on an aggregation of the model parameters received from the network access nodes).

Additionally or alternatively, the ML training methods may use a reinforcement training type of learning framework, where the local models learn from the reward which is connected to both the energy and performance objective of the RL training policy (it is although understood that it is not limited to an RL training framework alone).

FIG.4B thus illustrates a distributed learning-based AI technique for the system level power efficiency problem to optimize the cost of telemetry data upload instead of using a centralized system. The centralized location 416 may be selected depending on network topology, e.g. instead of a RIC the centralized location 416 may be a more convenient cell site with adequate compute facility, thus creating a hierarchical federated learning framework. In any case, the machine learning models 414 used are trained locally and the telemetry data may remain local and not incur the communication cost of sending it upstream to the centralized location.

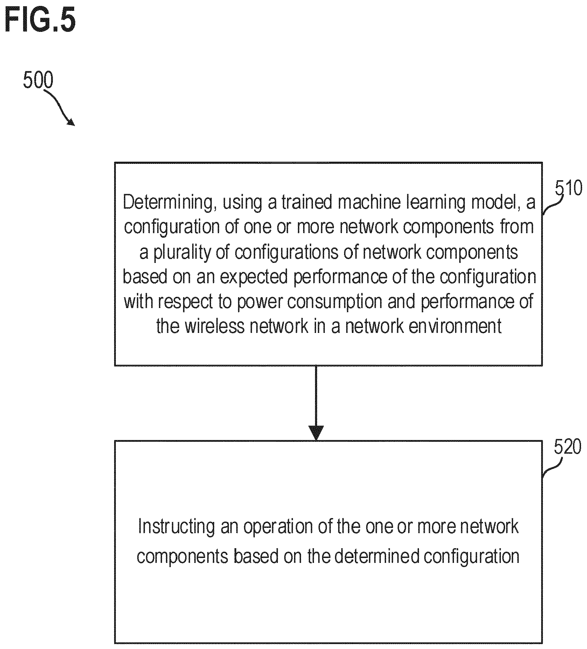

**FIG.5** show a flow diagram of a method 500 of operating a wireless network (e.g., a method of selecting a configuration for the operation of one or more network components), according to the present disclosure. The method 500 may be based on the method 210 and machine learning model 214, 300 described in relation to FIG.2A to FIG.3B, so that a repetition of the concepts already discussed above will be omitted. It is however understood that the discussion above in relation to the device 200 may apply in a corresponding manner to the method 500. The method 500 may be a computer-implemented method.

The method 500 may include, in 510, determining (e.g., selecting), using a trained machine learning model, a configuration of one or more network components from a plurality of configurations, based on an expected performance of the configuration with respect to power consumption and performance of the wireless network in a network environment. Illustratively, the method 500 may include, in 510, using a trained machine learning model to select from a plurality of configurations a configuration to apply for operating one or more network components of the wireless network. For example, the method 500 may include providing input data to the trained machine learning model, the input data describing a network environment of the wireless network.

The trained machine learning model may be configured to provide, based on the input data, output data representative of an expected performance of a plurality of configurations of the one or more network components with respect to power consumption and performance of the wireless network. Each configuration may be associated with a respective power saving mechanism. Determining the configuration, 510, may include selecting a configuration of the plurality of configurations based on the output data of the trained machine learning model, e.g. selecting the configuration with the greatest expected performance with respect to power consumption and performance of the wireless network among the plurality of configurations.

As an example, the output data of the trained machine learning model may include a plurality of scores, each score being associated with a respective configuration of the plurality of configurations and representative of the expected performance of that configuration. Determining the configuration, 510, may include selecting the configuration having the greatest score associated therewith.

The method 500 may further include, in 520, instructing an operation of the one or more network components based on the determined (e.g., selected) configuration. The method 500 may include transmitting instructions to the one or more network components (associated with the selected configuration) to control an operation thereof according to the selected configuration. Illustratively, the method 500 may include operating the one or more network components according to the selected configuration, e.g. performing wireless communication at the wireless network according to the selected configuration.

In the following, various examples are provided that refer to the device 200, processor 202, machine learning model 214, 300 and methods 320, 500.

Example 1 is a device for use in a wireless network, the device including: a processor configured to: provide input data to a trained machine learning model, the input data being representative of a network environment of the wireless network, wherein the trained machine learning model is configured to provide, based on the input data, output data representative of an expected performance of a plurality of configurations of network components with respect to power consumption and performance of the wireless network; select a configuration of a network component from the plurality of configurations based on the output data of the trained machine learning model; and instruct an operation of the network component according to the selected configuration. In an exemplary configuration the device may further include a memory coupled with the processor. The memory may store the input data provided to the trained machine learning model and/or the output data from the trained machine learning model, as an example.

Illustratively, the output data may be representative of one or more communication-based metrics (e.g., one or more of throughput, latency, coverage, etc.) and one or more energy-based metrics (e.g., one or more of power consumption, CPU cycles, compute complexity, etc.) associated with (each of) the plurality of configurations. Further illustratively, the output data may be representative of an expected performance of the wireless network with respect to the one or more communication-based metrics and one or more energy-based metrics in case an operation of the wireless network is configured according to (each of) the plurality of configurations.

In Example 2, the device according to example 1 may optionally further include that the output data of the trained machine learning model includes a plurality of scores, each score of the plurality of scores being representative of an expected performance of a respective configuration of the plurality of configurations of network components with respect to power consumption and performance of the wireless network.

In Example 3, the device according to example 2 may optionally further include that the processor is configured to select the configuration of the plurality of configurations having the greatest score associated therewith.

In Example 4, the device according to any one of examples 1 to 3, may optionally further include that each configuration of the plurality of configurations is associated with a power saving mechanism of the wireless network.

In Example 5, the device according to any one of examples 1 to 4 may optionally further include that the trained machine learning model includes a first prediction portion and a second prediction portion, that the first prediction portion is configured to provide, based on the input data representative of the network environment of the wireless network, output data representative of a power saving mechanism of the wireless network, and that the second prediction portion is configured to provide, based on the output data of the first prediction portion, output data representative of an expected performance of a plurality of configurations of network components with respect to power consumption and performance of the wireless network.

In Example 6, the device according to any one of examples 1 to 5 may optionally further include that the trained machine learning model is or includes a neural network.

In Example 7, the device according to example 5 may optionally further include that the first prediction portion is or includes a first neural network, and that the second prediction portion is or includes a second neural network.

In Example 8, the device according to any one of examples 1 to 7 may optionally further include that the plurality of configurations of network components includes two or more of: a configuration associated with an increase of system synchronization block periodicity; a configuration associated with a decrease of advertised bandwidth; a configuration associated with a variation of the bandwidth for each user equipment using a bandwidth part adaptation feature; a configuration associated with a use of a micro-discontinuous transmission technique on component carriers not used for initial access in a base station; a configuration associated with an increase of system information block periodicity; a configuration associated with a use of wake-up signaling features; a configuration associated with a use of discontinuous reception features; a configuration associated with an activation or deactivation of a carrier aggregation feature; a configuration associated with a secondary cell activation or deactivation; a configuration associated with a primary cell activation or deactivation; a configuration associated with a turning off of dual connectivity; a configuration associated with a turning off of pico cells or small cells while maintaining macro cells activated, or a turning off of macro cells while maintaining pico cells or small cells activated; a configuration associated with a turning off of a massive multiple-input multiple-output feature; and/or a configuration associated with a deactivation or offloading of a machine learning computation associated with a function of a protocol stack.

In Example 9, the device according to any one of examples 1 to 8 may optionally further include that the input data are representative of one or more of: load information; traffic volume; type of traffic; cell configuration; average cell capacity; latency; network access time; throughput; time of day; day and/or month; season of the year; wireless device capabilities; network planning and deployment strategy; and/or combinations thereof.

In Example 10, the device according to any one of examples 1 to 9 may optionally further include that the trained machine learning model is representative of a cell of the wireless network, and that the network component is or includes a cell of the wireless network (e.g., includes an environment at the cell).

In Example 11, the device according to example 10 may optionally further include that the input data are representative of one or more of: a configuration of the one or more cells and/or a deployment topology in proximity of the one or more cells.

In Example 12, the device according to example 10 or 11, may optionally further include that the plurality of configurations of network components includes one or more of (e.g., two or more of): a configuration associated with pushing one cell of the one or more cells in sleep state; a configuration associated with offloading traffic from one cell of the one or more cells onto another cell of the one or more cells; a configuration associated with offloading traffic from one cell of the one or more cells operating at a first frequency onto another cell of the one or more cells operating at a second frequency lower than the first frequency.

In Example 13, the device according to any one of examples 1 to 12 may optionally further include that the trained machine learning model is representative of a network access node of the wireless network, and that the network component is or includes a network access node of the wireless network.

In Example 14, the device according to example 13 may optionally further include that the input data are representative of one or more of: a deployment topology in proximity of the one or more network access nodes, a radio access technology of a network access node, a radio access technology of a network access node in relation to the radio access technology of another network access node, and/or combinations thereof.

In Example 15, the device according to any one of examples 1 to 14 may optionally further include that the plurality of configurations of network components includes a configuration associated with a group power saving of a plurality of network access nodes of the wireless network.

In Example 16, the device according to any one of examples 1 to 15 may optionally further include that the processor is configured to select the trained machine learning model from a plurality of trained machine learning models, and that the processor is configured to select the trained machine learning model dependent on the network environment.

In Example 17, the device according to any one of examples 1 to 16 may optionally further include that the input data includes telemetry data from one or more network access nodes of the wireless network.

In Example 18, the device according to example 17 may optionally further include that the telemetry data includes one or more of: cell traffic load; cell configuration of one or more cells in an area of interest; cell configuration of one or more cells in an area neighboring an area of interest; hardware information of the plurality of network components; and/or one or more key performance indicators; and/or combinations thereof.

Example 19 is a method of computer-implemented training of a machine learning model for operating a wireless network, the method including: using the machine learning model to determine (e.g., to select) a configuration of a network component of a wireless network; receiving a reward representative of a power consumption and performance of the wireless network according to the determined configuration; and adjusting values of parameters (e.g., weights) of the machine learning model using the reward.

In Example 20, the method according to example 19, may optionally further include that using the machine learning model to determine a configuration of a network component includes: providing to the machine learning model input data representative of a network environment, generating output data representative of an expected performance of a plurality of configurations of network components with respect to power consumption and performance of the wireless network, and selecting a configuration based on the output data.

In Example 21, the method according to example 19 or 20, may optionally further include operating the network component according to the selected configuration (e.g., performing wireless communication according to the selected configuration).

In Example 22, the method according to any one of examples 19 to 21 may optionally further include that receiving the reward includes determining (e.g., calculating, or estimating) a reduction in power consumption and a quality of wireless communication for network components operating according to the selected configuration.

In Example 23, the method according to any one of examples 19 to 22 may optionally further include that the reward is based on a difference between the power consumption and quality of wireless communication associated with the selected configuration and target data.

In Example 24, the method according to any one of examples 19 to 23 may optionally further include that adjusting values of parameters of the machine learning model using the reward includes adjusting learnable weights of the machine learning model.

In Example 25, the method according to any one of examples 19 to 24 may optionally further include that the reward may include one or more of: data from a macro base station with a plurality of small cells; data across a plurality of macro base stations and a plurality of small cells; data from a Centralized Radio Access Network system; and/or data from a plurality of Centralized Radio Access Network systems.

In Example 26, the method according to any one of examples 19 to 25 may optionally further include that the method is carried out in an orchestration and management entity of the wireless network or in an O-Cloud of the wireless network.

In Example 27, the method according to any one of examples 19 to 25 may optionally further include that the method is carried out in a network access node of the wireless network.

In Example 28, the method according to any one of examples 19 to 25 may optionally further include that a respective instance of the method is carried out in a network access node of a plurality of network access nodes of the wireless network, and that the method further includes each network access node transmitting model parameters to a centralized location of the wireless network.

In Example 29, the method according to example 28 may optionally further include that the centralized location includes a non-real time radio access network intelligent controller of the wireless network and/or a near-real time radio access network intelligent controller of the wireless network.

Example 30 is a non-transitory computer readable medium including instructions which, when the instructions are executed by a computer, cause the computer to carry out the method of any one of examples 19 to 29.

Example 31 is a computer program product including instructions which, when the program is executed by a computer, cause the computer to carry out the method of any one of examples 19 to 29.

In Example 32, the device according to any one of examples 1 to 18 may optionally further include that the machine learning model is trained with the method according to any one of examples 19 to 29.

Example 33 is a device for use in a wireless network, the device including: a processor configured to: provide input data to a trained machine learning model, the input data describing a network environment of the wireless network, wherein the trained machine learning model is configured to provide output data including a plurality of scores, each score of the plurality of scores being representative of an expected performance of a respective configuration of a plurality of configurations of one or more network components with respect to power consumption and performance of the wireless network based on the network environment that the input data describes; and instruct a configuration of the one or more network components based on the output data of the trained machine learning model. In an exemplary configuration the device may further include a memory coupled with the processor. The memory may store the input data provided to the trained machine learning model and/or the output data from the trained machine learning model, as an example.

In Example 34 the device according to example 33 may optionally further include one or more features of any one of examples 1 to 18.

Example 35 is a processor configured to: provide input data to a trained machine learning model, the input data representative of a network environment of the wireless network, wherein the trained machine learning model is configured to provide, based on the input data, output data representative of an expected performance of a plurality of configurations of network components with respect to power consumption and performance of the wireless network; select a configuration of a network component from the plurality of configurations based on the output data of the trained machine learning model; and instruct an operation of the network component according to the selected configuration.

In Example 36 the processor according to example 35 may optionally further include one or more features of any one of examples 1 to 18.

Example 37 is a method of operating a wireless network, the method including: determining, using a trained machine learning model, a configuration of a network component based on an expected performance of the configuration with respect to power consumption and performance of the wireless network in a network environment; and instructing an operation of the network component based on the determined configuration.

In Example 38 the method according to example 37, may optionally further include providing input data to the trained machine learning model, the input data representative of a network environment of the wireless network, wherein the trained machine learning model is configured to provide, based on the input data, output data representative of an expected performance of a plurality of configurations of network components with respect to power consumption and performance of the wireless network; selecting the configuration of the network component from the plurality of configurations based on the output data of the trained machine learning model; and instructing the operation of the network component according to the selected configuration.

In Example 39 the method according to example 38, may optionally further include that the output data of the trained machine learning model includes a plurality of scores, each score of the plurality of scores being representative of an expected performance of a respective configuration of the plurality of configurations of network components with respect to power consumption and performance of the wireless network.

In Example 40 the method according to example 38 or 39 may optionally further include selecting the configuration of the plurality of configurations having the greatest score associated therewith.

In Example 41 the method according to any one of examples 37 to 40 may optionally further include that each configuration of the plurality of configurations is associated with a power saving mechanism of the wireless network.

In Example 42 the method according to any one of examples 37 to 41 may optionally further include that the trained machine learning model includes a first prediction portion and a second prediction portion, that the first prediction portion is configured to provide, based on the input data representative of the network environment of the wireless network, output data representative of a power saving mechanism of the wireless network, and that the second prediction portion is configured to provide, based on the output data of the first prediction portion, output data representative of an expected performance of a plurality of configurations of network components with respect to power consumption and performance of the wireless network.

In Example 43 the method according to any one of examples 37 to 42 may optionally further include that the trained machine learning model is or includes a neural network.

In Example 44 the method according to example 42 may optionally further include that the first prediction portion is or includes a first neural network, and that the second prediction portion is or includes a second neural network.

In Example 45 the method according to any one of examples 38 to 44 may optionally further include that the plurality of configurations of network components includes two or more of: a configuration associated with an increase of system synchronization block periodicity; a configuration associated with a decrease of advertised bandwidth; a configuration associated with a variation of the bandwidth for each user equipment using a bandwidth part adaptation feature; a configuration associated with a use of a micro-discontinuous transmission technique on component carriers not used for initial access in a base station; a configuration associated with an increase of system information block periodicity; a configuration associated with a use of wake-up signaling features; a configuration associated with a use of discontinuous reception features; a configuration associated with an activation or deactivation of a carrier aggregation feature; a configuration associated with a secondary cell activation or deactivation; a configuration associated with a primary cell activation or deactivation; a configuration associated with a turning off of dual connectivity; a configuration associated with a turning off of pico cells or small cells while maintaining macro cells activated, or a turning off of macro cells while maintaining pico cells or small cells activated; a configuration associated with a turning off of a massive multiple-input multiple-output feature; and/or a configuration associated with a deactivation or offloading of a machine learning computation associated with a function of a protocol stack.

In Example 46 the method according to any one of examples 38 to 45 may optionally further include that the input data are representative of one or more of: load information; traffic volume; type of traffic; cell configuration; average cell capacity; latency; network access time; throughput; time of day; day and/or month; season of the year; wireless device capabilities; network planning and deployment strategy; and/or combinations thereof.

In Example 47 the method according to any one of examples 37 to 46 may optionally further include that the trained machine learning model is representative of a cell of the wireless network, and that the network component is or includes a cell of the wireless network.

In Example 48 the method according to example 47 may optionally further include that the input data are representative of one or more of: a configuration of the one or more cells and/or a deployment topology in proximity of the one or more cells.

In Example 49 the method according to example 47 or 48 may optionally further include that the plurality of configurations of network components includes one or more of (e.g., two or more of): a configuration associated with pushing one cell of the one or more cells in sleep state; a configuration associated with offloading traffic from one cell of the one or more cells onto another cell of the one or more cells; a configuration associated with offloading traffic from one cell of the one or more cells operating at a first frequency onto another cell of the one or more cells operating at a second frequency lower than the first frequency.

In Example 50 the method according to any one of examples 37 to 49 may optionally further include that the trained machine learning model is representative of a network access node of the wireless network, and that the network component is or includes a network access node of the wireless network.

In Example 51 the method according to example 50 may optionally further include that the input data are representative of one or more of: a deployment topology in proximity of the one or more network access nodes, a radio access technology of a network access node, a radio access technology of a network access node in relation to the radio access technology of another network access node, and/or combinations thereof.

In Example 52 the method according to any one of examples 38 to 51 may optionally further include that the plurality of configurations of network components includes a configuration associated with a group power saving of a plurality of network access nodes of the wireless network.

In Example 53 the method according to any one of examples 37 to 52, may optionally further include selecting the trained machine learning model from a plurality of trained machine learning models dependent on the network environment.

In Example 54 the method according to any one of examples 37 to 53 may optionally further include that the input data includes telemetry data from one or more network access nodes of the wireless network.

In Example 55 the method according to example 54 may optionally further include that the telemetry data includes one or more of: cell traffic load; cell configuration of one or more cells in an area of interest; cell configuration of one or more cells in an area neighboring an area of interest; hardware information of the plurality of network components; and/or one or more key performance indicators; and/or combinations thereof.

Example 56 is a non-transitory computer readable medium including instructions which, when the instructions are executed by a computer, cause the computer to carry out the method of any one of examples 37 to 55.

Example 57 is a computer program product including instructions which, when the program is executed by a computer, cause the computer to carry out the method of any one of examples 37 to 55.

In Example 58 the method according to any one of examples 37 to 55 may optionally further include that the machine learning model is trained with the method according to any one of examples 19 to 29.

Example 59 is a method of operating a wireless network, the method including: providing input data to a trained machine learning model, the input data describing a network environment of the wireless network, wherein the trained machine learning model is configured to provide, based on the input data, output data including a plurality of scores, each score of the plurality of scores being representative of an expected performance of a respective configuration of a plurality of configurations of one or more network components with respect to power consumption and performance of the wireless network; and instructing a configuration of the one or more network components based on the output data of the trained machine learning model (e.g., instructing an operation of the one or more network components based on a configuration selected according to the output data of the trained machine learning model).

In Example 60, the method according to example 59 may optionally further include one or more features of any one of examples 37 to 55.

Example 61 is a method of operating a wireless network, the method including: providing input data to a trained machine learning model, the input data describing a network environment of the wireless network, wherein the trained machine learning model is configured to provide, based on the input data, output data representative of an expected performance of a plurality of configurations of one or more network components with respect to power consumption and performance of the wireless network; selecting a configuration of the plurality of configurations based on the output data of the trained machine learning model; and instructing an operation of the one or more network components according to the selected configuration.

In Example 62, the method according to example 61 may optionally further include one or more features of any one of examples 37 to 55.

Example 63 is a device for use in a wireless network, the device including: processing means for: providing input data to a trained machine learning model, the input data representative of a network environment of the wireless network, wherein the trained machine learning model is configured to provide, based on the input data, output data representative of an expected performance of a plurality of configurations of network components with respect to power consumption and performance of the wireless network; selecting a configuration of a network component from the plurality of configurations based on the output data of the trained machine learning model; and instructing an operation of the network component according to the selected configuration. In an exemplary configuration the device may further include storage means coupled with the processing means. The storage means may be for storing the input data provided to the trained machine learning model and/or for storing the output data from the trained machine learning model, as an example.

The term "data" as used herein, for example in relation to "input data" or "output data", may be understood to include information in any suitable analog or digital form, e.g., provided as a file, a portion of a file, a set of files, a signal or stream, a portion of a signal or stream, a set of signals or streams, and the like. Further, the term "data" may also be used to mean a reference to information, e.g., in form of a pointer. The term "data", however, is not limited to the aforementioned examples and may take various forms and represent any information as understood in the art.

The term "processor" as used herein may be understood as any kind of technological entity that allows handling of data. The data may be handled according to one or more specific functions that the processor may execute. Further, a processor as used herein may be understood as any kind of circuit, e.g., any kind of analog or digital circuit. A processor may thus be or include an analog circuit, digital circuit, mixed-signal circuit, logic circuit (e.g., a hard-wired logic circuit or a programmable logic circuit), microprocessor (for example a Complex Instruction Set Computer (CISC) processor or a Reduced Instruction Set Computer (RISC) processor), Central Processing Unit (CPU), Graphics Processing Unit (GPU), Digital Signal Processor (DSP), Field Programmable Gate Array (FPGA), integrated circuit, Application Specific Integrated Circuit (ASIC), etc., or any combination thereof. A "processor" may also be a logic-implementing entity executing software, for example any kind of computer program, for example a computer program using a virtual machine code such as for example Java. A "processor" as used herein may also include any kind of cloud-based processing system that allows handling of data in a distributed manner, e.g. with a plurality of logic-implementing entities communicatively coupled with one another (e.g. over the internet) and each assigned to handling the data or part of the data. By way of illustration, an application running on a server and the server can also be a "processor". Any other kind of implementation of the respective functions, which will be described below in further detail, may also be understood as a processor. It is understood that any two (or more) of the processors detailed herein may be realized as a single entity with equivalent functionality or the like, and conversely that any single processor detailed herein may be realized as two (or more) separate entities with equivalent functionality or the like.

The term "system" detailed herein may be understood as a set of interacting elements, the elements may be, by way of example and not of limitation, one or more physical components (e.g., processors, transmitters and/or receivers) and/or one or more digital components (e.g., code segments, instructions, protocols). Generally, the system may include one or more functions to be operated (also referred to as "operating functions") of which each may be controlled for operating the whole system.

The term "memory" as used herein may be understood as a computer-readable medium (e.g., a non-transitory computer-readable medium), in which data or information can be stored for retrieval. References to "memory" included herein may thus be understood as referring to volatile or non-volatile memory, including random access memory (RAM), read-only memory (ROM), flash memory, solid-state storage, magnetic tape, hard disk drive, optical drive, 3D XPoint^{™}, among others, or any combination thereof. Furthermore, it is appreciated that registers, shift registers, processor registers, data buffers, among others, are also embraced herein by the term memory. It is also appreciated that a single component referred to as "memory" or "a memory" may be composed of more than one different type of memory, and thus may refer to a collective component including one or more types of memory. It is readily understood that any single memory component may be separated into multiple collectively equivalent memory components, and vice versa. Furthermore, while memory may be depicted as separate from one or more other components (such as in the drawings), it is understood that memory may be integrated within another component, such as on a common integrated chip.

The term "software" refers to any type of executable instruction, including firmware.

As used herein, a "cell" in the context of telecommunications may be understood as a sector served by a network access node. A wireless network may be distributed over a plurality of cells. Accordingly, a cell may be a set of geographically co-located antennas that correspond to a particular sector of a network access node. A network access node can thus serve one or more cells (or sectors), where the cells are characterized by distinct communication channels. Furthermore, the term "cell" may be utilized to refer to any of a macro cell, micro cell, femto cell, pico cell, etc. An "inter-cell handover" may be understood as a handover from a first "cell" to a second "cell", where the first "cell" is different from the second "cell". "Inter-cell handovers" may be characterized as either "inter-network access node handovers" or "intra-network access node handovers". "Inter-network access node handovers" may be understood as a handover from a first "cell" to a second "cell", where the first "cell" is provided at a first network access node and the second "cell" is provided at a second, different, network access node. "Intra-network access node handovers" may be understood as a handover from a first "cell" to a second "cell", where the first "cell" is provided at the same network access node as the second "cell". A "serving cell" may be understood as a "cell" that a wireless communication device is currently connected to according to the mobile communications protocols of the associated mobile communications network standard. In case a cell is served by a mobile network access node, the cell itself may be non-stationary, e.g. may be a mobile cell.

The present disclosure may utilize or be related to radio communication technologies. While some examples may refer to specific radio communication technologies, the examples provided herein may be similarly applied to various other radio communication technologies, both existing and not yet formulated, particularly in cases where such radio communication technologies share similar features as disclosed regarding the examples described herein. For purposes of this disclosure, radio communication technologies may be classified as one of a Short Range radio communication technology or Cellular Wide Area radio communication technology. Short Range radio communication technologies may include Bluetooth, WLAN (e.g., according to any IEEE 802.11 standard), and other similar radio communication technologies. Exemplary Cellular Wide Area radio communication technologies that the present disclosure may utilize include, but are not limited to: Long Term Evolution (LTE), Long Term Evolution-Advanced (LTE-A), 5th Generation (5G) communication systems, a Global System for Mobile Communications (GSM) radio communication technology, a General Packet Radio Service (GPRS) radio communication technology, an Enhanced Data Rates for GSM Evolution (EDGE) radio communication technology, and/or a Third Generation Partnership Project (3GPP) radio communication technology (e.g. UMTS (Universal Mobile Telecommunications System), FOMA (Freedom of Multimedia Access), 3GPP LTE (Long Term Evolution), 3GPP LTE Advanced (Long Term Evolution Advanced)), CDMA2000 (Code division multiple access 2000), CDPD (Cellular Digital Packet Data), Mobitex, 3G (Third Generation), CSD (Circuit Switched Data), HSCSD (High-Speed Circuit-Switched Data), UMTS (3G) (Universal Mobile Telecommunications System (Third Generation)), W-CDMA (UMTS) (Wideband Code Division Multiple Access (Universal Mobile Telecommunications System)), HSPA (High Speed Packet Access), HSDPA (High-Speed Downlink Packet Access), HSDPA Plus (HSDPA+), HSUPA (High-Speed Uplink Packet Access), HSUPA Plus (HSUPA+), HSPA+ (High Speed Packet Access Plus), UMTS-TDD (Universal Mobile Telecommunications System - Time-Division Duplex), TD-CDMA (Time Division - Code Division Multiple Access), TD-CDMA (Time Division - Synchronous Code Division Multiple Access), 3GPP Rel. 8 (Pre-4G) (3rd Generation Partnership Project Release 8 (Pre-4th Generation)), 3GPP Rel. 9 (3rd Generation Partnership Project Release 9), 3GPP Rel. 10 (3rd Generation Partnership Project Release 10), 3GPP Rel. 11 (3rd Generation Partnership Project Release 11), 3GPP Rel. 12 (3rd Generation Partnership Project Release 12), 3GPP Rel. 13 (3rd Generation Partnership Project Release 12), 3GPP Rel. 14 (3rd Generation Partnership Project Release 14), 3GPP Rel. 15 (3rd Generation Partnership Project Release 15), 3GPP Rel. 16 (3rd Generation Partnership Project Release 16), 3GPP Rel. 17 (3rd Generation Partnership Project Release 17), 3GPP Rel. 18 (3rd Generation Partnership Project Release 18), 3GPP 5G, 3GPP LTE Extra, LTE-Advanced Pro, LTE Licensed-Assisted Access (LAA), MuLTEfire, UTRA (UMTS Terrestrial Radio Access), E-UTRA (Evolved UMTS Terrestrial Radio Access), LTE Advanced (4G) (Long Term Evolution Advanced (4th Generation)), cdmaOne (2G), CDMA2000 (3G) (Code division multiple access 2000 (Third generation)), EV-DO (Evolution-Data Optimized or Evolution-Data Only), AMPS (1G) (Advanced Mobile Phone System (1st Generation)), TACS/ETACS (Total Access Communication System/Extended Total Access Communication System), D-AMPS (2G) (Digital AMPS (2nd Generation)), PTT (Push-to-talk), MTS (Mobile Telephone System), IMTS (Improved Mobile Telephone System), AMTS (Advanced Mobile Telephone System), OLT (Norwegian for Offentlig Landmobil Telefoni, Public Land Mobile Telephony), MTD (Swedish abbreviation for Mobiltelefonisystem D, or Mobile telephony system D), Autotel/PALM (Public Automated Land Mobile), ARP (Finnish for Autoradiopuhelin, "car radio phone"), NMT (Nordic Mobile Telephony), Hicap (High capacity version of NTT (Nippon Telegraph and Telephone)), CDPD (Cellular Digital Packet Data), Mobitex, DataTAC, iDEN (Integrated Digital Enhanced Network), PDC (Personal Digital Cellular), CSD (Circuit Switched Data), PHS (Personal Handy-phone System), WiDEN (Wideband Integrated Digital Enhanced Network), iBurst, Unlicensed Mobile Access (UMA, also referred to as also referred to as 3GPP Generic Access Network, or GAN standard)), Zigbee, Bluetooth^{®}, Wireless Gigabit Alliance (WiGig) standard, Worldwide Interoperability for Microwave Access (WiMax) (e.g., according to an IEEE 802.16 radio communication standard, e.g., WiMax fixed or WiMax mobile), mmWave standards in general (wireless systems operating at 10-90 GHz and above such as WiGig, IEEE 802.11ad, IEEE 802.11ay, etc.), technologies operating above 300 GHz and THz bands, (3GPP/LTE based or IEEE 802.11p and other) Vehicle-to-Vehicle (V2V) and Vehicle-to-X (V2X) and Vehicle-to-Infrastructure (V2I) and Infrastructure-to-Vehicle (I2V) communication technologies, 3GPP cellular V2X, DSRC (Dedicated Short Range Communications) communication arrangements such as Intelligent-Transport-Systems, etc. Cellular Wide Area radio communication technologies also include "small cells" of such technologies, such as microcells, femtocells, and picocells. Cellular Wide Area radio communication technologies may be generally referred to herein as "cellular" communication technologies. As used herein, a first radio communication technology may be different from a second radio communication technology if the first and second radio communication technologies are based on different communication standards.

The term "5G" as used herein refers to wireless technologies as provided by the 3GPP and International Telecommunication Union (ITU) standards. This may include spectral use overlapping with the existing LTE frequency range (e.g., 600 MHz to 6 GHz) and also include spectral use in the millimeter wave bands (e.g., 24-86 GHz). Also, the terms 5G, New Radio (NR), or 5G NR may be used interchangeably. NR is designed to operate over a wide array of spectrum bands, for example, from low-frequency bands below about 1 gigahertz (GHz) and mid-frequency bands from about 1 GHz to about 6 GHz, to high-frequency bands such as millimeter wave (mmWave) bands. NR is also designed to operate across different spectrum types, from licensed spectrum to unlicensed and shared spectrum.

The present disclosure may use such radio communication technologies according to various spectrum management schemes, including, but not limited to, dedicated licensed spectrum, unlicensed spectrum, (licensed) shared spectrum (such as LSA, "Licensed Shared Access," in 2.3-2.4 GHz, 3.4-3.6 GHz, 3.6-3.8 GHz and further frequencies and SAS, "Spectrum Access System," in 3.55-3.7 GHz and further frequencies), and may use various spectrum bands including, but not limited to, IMT (International Mobile Telecommunications) spectrum (including 450 - 470 MHz, 790 - 960 MHz, 1710 - 2025 MHz, 2110 - 2200 MHz, 2300 - 2400 MHz, 2500 - 2690 MHz, 698-790 MHz, 610 - 790 MHz, 3400 - 3600 MHz, etc., where some bands may be limited to specific region(s) and/or countries), IMT-advanced spectrum, IMT-2020 spectrum (expected to include 3600-3800 MHz, 3.5 GHz bands, 700 MHz bands, bands within the 24.25-86 GHz range, etc.), spectrum made available under FCC's "Spectrum Frontier" 5G initiative (including 27.5 - 28.35 GHz, 29.1 - 29.25 GHz, 31 - 31.3 GHz, 37 - 38.6 GHz, 38.6 - 40 GHz, 42 - 42.5 GHz, 57 - 64 GHz, 64 - 71 GHz, 71 - 76 GHz, 81 - 86 GHz and 92 - 94 GHz, etc.), the ITS (Intelligent Transport Systems) band of 5.9 GHz (typically 5.85-5.925 GHz) and 63-64 GHz, bands currently allocated to WiGig such as WiGig Band 1 (57.24-59.40 GHz), WiGig Band 2 (59.40-61.56 GHz) and WiGig Band 3 (61.56-63.72 GHz) and WiGig Band 4 (63.72-65.88 GHz), the 70.2 GHz - 71 GHz band, any band between 65.88 GHz and 71 GHz, bands currently allocated to automotive radar applications such as 76-81 GHz, and future bands including 94-300 GHz and above. Furthermore, aspects described herein can also employ radio communication technologies on a secondary basis on bands such as the TV White Space bands (typically below 790 MHz) where in particular the 400 MHz and 700 MHz bands are prospective candidates. Besides cellular applications, specific applications for vertical markets may be addressed such as PMSE (Program Making and Special Events), medical, health, surgery, automotive, low-latency, drones, etc. applications. Furthermore, aspects described herein may also use radio communication technologies with a hierarchical application, such as by introducing a hierarchical prioritization of usage for different types of users (e.g., low/medium/high priority, etc.), based on a prioritized access to the spectrum e.g., with highest priority to tier-1 users, followed by tier-2, then tier-3, etc. users, etc. Aspects described herein can also use radio communication technologies with different Single Carrier or OFDM flavors (CP-OFDM, SC-FDMA, SC-OFDM, filter bank-based multicarrier (FBMC), OFDMA, etc.) and in particular 3GPP NR (New Radio), which can include allocating the OFDM carrier data bit vectors to the corresponding symbol resources.

Unless explicitly specified, the term "transmit" encompasses both direct (point-to-point) and indirect transmission (via one or more intermediary points). Similarly, the term "receive" encompasses both direct and indirect reception. Furthermore, the terms "transmit", "receive", "communicate", and other similar terms encompass both physical transmission (e.g., the transmission of radio signals) and logical transmission (e.g., the transmission of digital data over a logical software-level connection). For example, a processor may transmit or receive data over a software-level connection with another processor in the form of radio signals, where radio-layer components carry out the physical transmission and reception, such as radio frequency (RF) transceivers and antennas, and the processors perform the logical transmission and reception over the software-level connection.

The term "communicate" encompasses one or both of transmitting and receiving, i.e., unidirectional or bidirectional communication in one or both of the incoming and outgoing directions. In general, the term "communicate" may include the exchange of data, e.g., unidirectional or bidirectional exchange in one or both of the incoming and outgoing directions.

The term "calculate" encompasses both 'direct' calculations via a mathematical expression/formula/relationship and 'indirect' calculations via lookup or hash tables and other array indexing or searching operations.

As utilized herein, the term "derived from" designates being obtained directly or indirectly from a specific source. Accordingly, data derived from a source includes data obtained directly from the source or indirectly from the source, i.e. through one or more secondary agents.

The word "exemplary" is used herein to mean "serving as an example, instance, or illustration". Any embodiment or design described herein as "exemplary" is not necessarily to be construed as preferred or advantageous over other embodiments or designs.

The words "plural" and "multiple" in the description and the claims, if any, are used to expressly refer to a quantity greater than one. Accordingly, any phrases explicitly invoking the aforementioned words (e.g. "a plurality of [objects]", "multiple [objects]") referring to a quantity of objects is intended to expressly refer more than one of the said objects. For instance, the phrase "a plurality" may be understood to include a numerical quantity greater than or equal to two (e.g., two, three, four, five, [...], etc.). The terms "group", "set", "collection", "series", "sequence", "grouping", "selection", etc., and the like in the description and in the claims, if any, are used to refer to a quantity equal to or greater than one, i.e. one or more. Accordingly, the phrases "a group of [objects]", "a set of [objects]", "a collection of [objects]", "a series of [objects]", "a sequence of [objects]", "a grouping of [objects]", "a selection of [objects]", "[object] group", "[object] set", "[object] collection", "[object] series", "[object] sequence", "[object] grouping", "[object] selection", etc., used herein in relation to a quantity of objects is intended to refer to a quantity of one or more of said objects. It is appreciated that unless directly referred to with an explicitly stated plural quantity (e.g. "two [objects]", "three of the [objects]", "ten or more [objects]", "at least four [objects]", etc.) or express use of the words "plural", "multiple", or similar phrases, references to quantities of objects are intended to refer to one or more of said objects.

Throughout the drawings, it should be noted that like reference numbers are used to depict the same or similar elements, features, and structures, unless otherwise noted.

The phrase "at least one" and "one or more" may be understood to include a numerical quantity greater than or equal to one (e.g., one, two, three, four, [...], etc.). The phrase "at least one of' with regard to a group of elements may be used herein to mean at least one element from the group consisting of the elements. For example, the phrase "at least one of' with regard to a group of elements may be used herein to mean a selection of: one of the listed elements, a plurality of one of the listed elements, a plurality of individual listed elements, or a plurality of a multiple of individual listed elements.

As used herein, a signal (e.g., data) that is "indicative of' a value or other information may be a digital or analog signal that encodes or otherwise communicates the value or other information in a manner that can be decoded by and/or cause a responsive action in a component receiving the signal. The signal may be stored or buffered in computer readable storage medium prior to its receipt by the receiving component and the receiving component may retrieve the signal from the storage medium. Further, a "value" that is "indicative of' some quantity, state, or parameter may be physically embodied as a digital signal, an analog signal, or stored bits that encode or otherwise communicate the value.

Any vector and/or matrix notation utilized herein is exemplary in nature and is employed solely for purposes of explanation. Accordingly, aspects of this disclosure accompanied by vector and/or matrix notation are not limited to being implemented solely using vectors and/or matrices, and that the associated processes and computations may be equivalently performed with respect to sets, sequences, groups, etc., of data, observations, information, signals, samples, symbols, elements, etc.

While the above descriptions and connected figures may depict electronic device components as separate elements, skilled persons will appreciate the various possibilities to combine or integrate discrete elements into a single element. Such may include combining two or more circuits for form a single circuit, mounting two or more circuits onto a common chip or chassis to form an integrated element, executing discrete software components on a common processor core, etc. Conversely, skilled persons will recognize the possibility to separate a single element into two or more discrete elements, such as splitting a single circuit into two or more separate circuits, separating a chip or chassis into discrete elements originally provided thereon, separating a software component into two or more sections and executing each on a separate processor core, etc.

It is appreciated that implementations of methods detailed herein are demonstrative in nature, and are thus understood as capable of being implemented in a corresponding device. Likewise, it is appreciated that implementations of devices detailed herein are understood as capable of being implemented as a corresponding method. It is thus understood that a device corresponding to a method detailed herein may include one or more components configured to perform each aspect of the related method.

All acronyms defined in the above description additionally hold in all claims included herein.

While the invention has been particularly shown and described with reference to specific aspects, it should be understood by those skilled in the art that various changes in form and detail may be made therein without departing from the spirit and scope of the invention as defined by the appended claims. The scope of the invention is thus indicated by the appended claims and all changes, which come within the meaning and range of equivalency of the claims, are therefore intended to be embraced.

## Claims

1. A device (200) for use in a wireless network, the device (200) comprising:
a processor (202) configured to:
provide input data (212) to a trained machine learning model (214), the input data representative of a network environment of the wireless network,
wherein the trained machine learning model (214) is configured to provide, based on the input data (212), output data (218) representative of an expected performance of a plurality of configurations (220) of network components with respect to power consumption and performance of the wireless network;
select a configuration of a network component from the plurality of configurations (220) based on the output data (218) of the trained machine learning model (214); and
instruct an operation of the network component according to the selected configuration; and
a memory (204) coupled with the processor (202), the memory (204) storing the input data (212) provided to the trained machine learning model (214) and/or the output data (218) from the trained machine learning model (214).

2. The device (200) according to claim 1,
wherein the output data (218) of the trained machine learning model (214) comprises a plurality of scores,
each score of the plurality of scores being representative of an expected performance of a respective configuration of the plurality of configurations (220) of network components with respect to power consumption and performance of the wireless network.

3. The device (200) according to claim 2,
wherein the processor (202) is configured to select the configuration of the plurality of configurations (220) having the greatest score associated therewith.

4. The device (200) according to any one of claims 1 to 3,
wherein each configuration of the plurality of configurations (220) is associated with a power saving mechanism of the wireless network.

5. The device (200) according to any one of claims 1 to 4,
wherein the trained machine learning model (214) comprises a first prediction portion (302a) and a second prediction portion (302b),
wherein the first prediction portion (302a) is configured to provide, based on the input data (212) representative of the network environment of the wireless network, output data (316) representative of a power saving mechanism of the wireless network, and
wherein the second prediction portion (302b) is configured to provide, based on the output data (316) of the first prediction portion (302a), output data (318) representative of an expected performance of a plurality of configurations of network components with respect to power consumption and performance of the wireless network.

6. The device (200) according to any one of claims 1 to 5,
wherein the trained machine learning model (214) is or comprises a neural network (302).

7. The device (200) according to claim 5,
wherein the first prediction portion (302a) is or comprises a first neural network, and
wherein the second prediction portion (302b) is or comprises a second neural network.

8. The device (200) according to any one of claims 1 to 7,
wherein the plurality of configurations (220) of network components comprises two or more of:
a configuration associated with an increase of system synchronization block periodicity;
a configuration associated with a decrease of advertised bandwidth;
a configuration associated with a variation of the bandwidth for each user equipment using a bandwidth part adaptation feature;
a configuration associated with a use of a micro-discontinuous transmission technique on component carriers not used for initial access in a base station;
a configuration associated with an increase of system information block periodicity;
a configuration associated with a use of wake-up signaling features;
a configuration associated with a use of discontinuous reception features;
a configuration associated with an activation or deactivation of a carrier aggregation feature;
a configuration associated with a secondary cell activation or deactivation;
a configuration associated with a primary cell activation or deactivation;
a configuration associated with a turning off of dual connectivity;
a configuration associated with a turning off of pico cells or small cells while maintaining macro cells activated, or a turning off of macro cells while maintaining pico cells or small cells activated;
a configuration associated with a turning off of a massive multiple-input multiple-output feature; and/or
a configuration associated with a deactivation or offloading of a machine learning computation associated with a function of a protocol stack.

9. The device (200) according to any one of claims 1 to 8,
wherein the input data (212) are representative of one or more of: load information; traffic volume; type of traffic; cell configuration; average cell capacity; latency; network access time; throughput; time of day; day and/or month; season of the year; wireless device capabilities; network planning and deployment strategy; and/or combinations thereof.

10. The device (200) according to any one of claims 1 to 9,
wherein the trained machine learning model (214) is representative of a cell of the wireless network, and
wherein the network component is or comprises a cell of the wireless network.

11. The device (200) according to any one of claims 1 to 10,
wherein the trained machine learning model (214) is representative of a network access node of the wireless network, and
wherein the network component is or includes a network access node of the wireless network.

12. The device (200) according to any one of claims 1 to 11,
wherein the processor (202) is configured to select the trained machine learning model (214) from a plurality of trained machine learning models, and
wherein the processor (202) is configured to select the trained machine learning model dependent on the network environment.

13. A method (500) of operating a wireless network, the method (500) comprising:
determining (510), using a trained machine learning model, a configuration of a network component from a plurality of configurations of network components, based on an expected performance of the configuration with respect to power consumption and performance of the wireless network in a network environment; and
instructing (520) an operation of the network component based on the determined configuration.

14. The method (500) according to claim 13, further comprising:
providing input data to the trained machine learning model, the input data representative of a network environment of the wireless network,
wherein the trained machine learning model is configured to provide, based on the input data, output data representative of an expected performance of the plurality of configurations of network components with respect to power consumption and performance of the wireless network;
selecting the configuration of the network component from the plurality of configurations based on the output data of the trained machine learning model; and
instructing the operation of the network component according to the selected configuration.

15. A computer program product comprising instructions which, when the program is executed by a computer, cause the computer to carry out the method of claim 13 or 14.
